# EUROPÄISCHE PATENTSCHRIFT

(11) **EP 3 231 261 B1**
(45) Veröffentlichungstag und Bekanntmachung des Hinweises auf die Patenterteilung: **13.11.2019**
(21) Anmeldenummer: 15808378.2
(22) Anmeldetag: 10.12.2015
(51) Int. Cl.: H05K 1/02, H05K 1/03, H05K 3/46, H05K 1/18, C08J 5/24, H01L 23/538

(54) **LEITERPLATTE MIT EINEM ASYMMETRISCHEN SCHICHTENAUFBAU**
PRINTED CIRCUIT BOARD WITH ASYMMETRICAL STACK OF LAYERS
CIRCUIT IMPRIMÉ AVEC EMPILEMENT ASYMÉTRIQUE DE COUCHES

(30) Priorität: 11.12.2014 DE 102014118464
(43) Veröffentlichungstag der Anmeldung: 18.10.2017
(73) Patentinhaber: AT & S Austria Technologie & Systemtechnik Aktiengesellschaft, 8700 Leoben (AT)
(72) Erfinder: ZLUC, Andreas, 8700 Leoben (AT); WEIDINGER, Gerald, 8700 Leoben (AT); SCHOBER, Mario, 8793 Trofaiach (AT); STAHR, Hannes, 8605 St.Lorenzen im Mürztal (AT); SCHWARZ, Timo, 8770 St. Michael i.O. (AT); GRUBER, Benjamin, 8712 Niklasdorf (AT)
(74) Vertreter: Dilg, Haeusler, Schindelmann Patentanwaltsgesellschaft mbH
(86) Internationale Anmeldenummer: PCT/EP2015/079200
(87) Internationale Veröffentlichungsnummer: WO 2016/091992

(56) Entgegenhaltungen:
- EP-A1- 1 650 253
- EP-A1- 2 042 655
- US-A1- 2002 140 095
- US-A1- 2008 057 299
- US-A1- 2011 259 630
- US-A1- 2013 026 632
- US-A1- 2013 307 113

## Beschreibung

### Technisches Gebiet

Die vorliegende Erfindung betrifft allgemein das technische Gebiet von Bauelementeträgern bzw. Leiterplatten, auf bzw. an welchen elektronische Baugruppen aufgebaut werden. Die vorliegende Erfindung betrifft insbesondere eine Leiterplatte, welche trotz einer sehr geringen Dicke eine hohe mechanische Formstabilität aufweist. Die vorliegende Erfindung betrifft ferner ein Verfahren zum Herstellen einer solchen Leiterplatte.

### Hintergrund der Erfindung

In der modernen Elektronikfertigung gibt es seit vielen Jahren die Tendenz, immer komplexere elektronische Baugruppen innerhalb eines immer kleiner werdenden Bauraums aufzubauen. Dies wird als Tendenz zur Miniaturisierung bezeichnet.

Eine elektronische Baugruppe, welche typischerweise eine Mehrzahl von elektronischen Bauelementen aufweist, wird in bekannter Weise auf einen Bauelementeträger bzw. einer Leiterplatte aufgebaut. Leiterplatten können starr oder auch flexibel sein. Für eine vollständige Miniaturisierung müssen daher auch die Leiterplatten klein sein und neben einer geringen flächigen Abmessung auch eine geringe Dicke aufweisen.

Eine Leiterplatte besteht typischerweise aus einem Schichtenaufbau aus mehreren Schichten, welche zumindest eine dielektrische Schicht und metallische Schichten umfassen. Viele Leiterplatten sind als sog. Multilayer-Leiterplatten realisiert, welche nicht nur an der Oberseite und an der Unterseite eine metallische Schicht sondern auch in der Mitte zwischen zwei dielektrischen Schichten eingebettet zumindest eine weitere metallische Schicht aufweisen.

US 2011/259630 A1 offenbart eine Leiterplatte, die ein Substrat enthält, welches eine elektrisch isolierende Schicht aufweist, in welcher ein Hohlraum ausgebildet ist. Eine elektronische Komponente befindet sich in diesem Hohlraum. Eine Schicht aus einem isolierenden Material ist auf einer Seite des Substrates ausgebildet, um die elektronische Komponente einzubetten bzw. zu bedecken Anschlusskontakte der elektronischen Komponente sind mit einer ersten strukturierten Verdrahtungsschicht verbunden, welche sich unterhalb der elektrisch isolierenden Schicht befindet.

US 2013/307113 A1 offenbart eine Halbleitervorrichtung mit einem in einem Schichtenverbund eingebetteten Halbleiterchip. Der Schichtenverbund weist mehrere elektrisch isolierende bzw. dielektrische Schichten auf, zwischen welchen jeweils eine elektrisch leitende Verdrahtungsschicht ausgebildet ist. Der Halbleiterchip befindet sich in einer Kavität, welche in den dielektrischen Schichten ausgebildet ist. An seiner Unterseite ist der Halbleiterchip mittels einer Klebeschicht befestigt. Elektrische Kontakte an der Oberseite des Halbleiterchips sind über metallisierte Vias mit der Verdrahtungsschicht elektrisch leitend verbunden.

US 2002/140095 A1 offenbart eine Halbleiterverpackung mit einem eingebetteten Halbleiterchip. die Halbleiterverpackung weist eine Basis auf, an deren Rändern elektrische Anschlüsse ausgebildet sind. Auf der Basis bzw. auf den elektrischen Anschlüssen ist eine strukturierte Verdrahtungsschicht ausgebildet. Auf der strukturierten Verdrahtungsschicht befindet sich eine (elektrisch isolierende bzw. dielektrische) Harzschicht. Auf der Harzschicht sowie auf dem Bereich der Basis, welcher nicht von der strukturierten Verdrahtungsschicht bedeckt ist, befindet sich eine (dielektrische) Harz-Vergussmasse. In dieser Harz-Vergussmasse ist eine Kavität ausgebildet, in welcher sich der Halbleiterchip befindet.

US 2013/026632 A1 offenbart ein Substrat, in dem ein Halbleiterelement eingebettet ist und welches eine elektrische Verdrahtung enthält. Das Substrat weist eine isolierende Basisschicht auf, an deren Unterseite eine strukturierte metallische Schicht ausgebildet ist, welche eine elektrische Verdrahtung darstellt. Auf einem Teil der isolierenden Basisschicht befindet sich eine Klebeschicht, an deren Oberseite die Unterseite des eingebetteten Halbleiterelements anhaftet. Das Halbleiterelement ist von einer peripheren isolierenden Schicht umgeben, welche auf der isolierenden Basisschicht ausgebildet ist.

Der Erfindung liegt die Aufgabe zugrunde, die Struktur und die Herstellung von Leiterplatten dahingehend zu verbessern, so dass diese trotz einer kleinen Dicke eine hohe mechanische Formstabilität aufweisen.

### Zusammenfassung der Erfindung

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Gemäß einem ersten Aspekt der Erfindung wird ein Leiterplatte beschrieben, welche einen Schichtenverbund aufweist. Der Schichtenverbund weist auf (a) eine dielektrische Schicht auf, welche (a1) parallel zu einer xy-Ebene, die durch eine x-Achse und eine dazu senkrechte y-Achse aufgespannt ist, eine flächige Ausdehnung aufweist und (a2) entlang einer z-Achse, welche senkrecht zu der x-Achse und zu der y-Achse ist, eine Schichtdicke aufweist; und (b) zumindest eine metallische Schicht, welche flächig an der dielektrischen Schicht angebracht ist. Der Schichtenverbund ist entlang der z-Achse frei von einer Symmetrieebene, welche parallel zu der xy-Ebene orientiert ist. Die dielektrische Schicht weist ein dielektrisches Material auf, welches (i) ein Elastizitätsmodul E im Bereich zwischen 1 und 20 GPa und (ii) entlang der x-Achse und entlang der y-Achse einen thermischen Ausdehnungskoeffizienten im Bereich zwischen 0 und 17 ppm/K hat.

Der vorliegenden Leiterplatte liegt die Erkenntnis zugrunde, dass durch die mechanischen Eigenschaften des dielektrischen Materials Leiterplatten mit einem asymmetrischen Schichtenaufbau auch bei Temperaturschwankungen eine hohe mechanische Formstabilität aufweisen, wenn der asymmetrische Schichtenaufbau lediglich eine geringe Schichtdicke aufweist. Dadurch können bei gleicher mechanischer Formstabilität im Vergleich zu bekannten Leiterplatten, welche typischerweise mit dem flammenhemmenden Material FR4 aufgebaut sind, deutlich dünnere Leiterplatten aufgebaut werden und damit ein wertvoller Beitrag für eine weitere Miniaturisierung von elektronischen Baugruppen geleistet werden.

Das beschriebene dielektrische Material ist im Vergleich zu dem bekannten Material FR4 relativ weich und nachgiebig. Durch diese Eigenschaft kommt es nur zu geringen thermisch induzierten mechanischen Belastungen, so dass Verwerfungen einer Schicht der beschriebenen asymmetrischen Leiterplatte zuverlässig vermieden werden können.

Die metallische Schicht kann an der dielektrischen Schicht unmittelbar, d.h. direkt, oder mittelbar, d.h. indirekt über eine oder mehrere Zwischenschichten, angebracht sein.

Es wird darauf hingewiesen, dass die vorstehend beschriebene überraschend hohe Formstabilität insbesondere bei Temperaturschwankungen von den Erfindern auch experimentell anhand von sog. Reflow-Tests nachgewiesen werden konnte. Bei solchen Reflow-Tests wird die Leiterplatte ausgehend von Raumtemperatur solch hohen Temperaturen ausgesetzt, welche typischerweise in einem Reflow-Ofen vorkommen und welche ausreichen, um Lotpaste, welche sich zwischen Bauelement-Anschlusskontakten von bestückten Bauelementen und Anschlusspads auf der Oberfläche einer Leiterplatte befindet, aufzuschmelzen und die betreffenden Bauelemente an der Oberseite der Leiterplatte anzulöten. Erfindungsgemäße Leiterplatten haben mindestens zehn Reflow-Zyklen unbeschädigt überstanden, wobei ein Reflow-Zyklus eine Temperaturänderung von Raumtemperatur auf eine bestimmte Reflow-Temperatur und zurück umfasst.

Das erfindungsgemäße dielektrische Material weist einen thermischen Ausdehnungskoeffizienten im Bereich zwischen Null und 17°ppm/K auf. In diesem Zusammenhang wird darauf hingewiesen, dass es aus technischer Sicht kein Problem ist, ein Material mit einem thermischen Ausdehnungskoeffizienten von Null herzustellen. Es ist nämlich allgemein bekannt, dass es auch Materialien, insbesondere Kunststoffmaterialien, mit einem negativen thermischen Ausdehnungskoeffizienten gibt. Um ein Material mit einem thermischen Ausdehnungskoeffizienten von Null herzustellen, ist es also lediglich erforderlich, ein Material mit einem negativen thermischen Ausdehnungskoeffizienten und ein Material mit einem positiven thermischen Ausdehnungskoeffizienten in geeigneter Weise zu mischen, so dass sich die positive und negative Ausdehnung zumindest annähernd kompensieren. Nachfolgend wird der Begriff thermischer Ausdehnungskoeffizient auch als CTE (Coefficient of Thermal Expansion) bezeichnet.

Hinsichtlich des Wertebereichs des Elastizitätsmoduls E von 1 GPa bis 20 GPa sind die Erfinder zu der Erkenntnis gelangt, dass sich die untere Grenze von 1 GPa dadurch ergibt, dass das dielektrische Material für eine prozesssichere Verarbeitung und insbesondere für einem Vorgang des Verpressens oder Presssens der verschiedenen Schichten der Leiterplatte nicht zu weich sein darf. Bei einem Überschreiten der oberen Grenze von 20 GPa ergibt sich für einen solchen Vorgang des Verpressens kein ausreichendes Fließverhalten.

Es wird darauf hingewiesen, dass sich die in diesem Dokument genannten Werte für das Elastizitätsmodul E auf eine Temperatur von 25°C beziehen.

Es hat sich anhand experimenteller Untersuchungen herausgestellt, dass die dielektrische Schicht auch bei starken Temperaturschwankungen keine oder lediglich sehr kleine Verwerfungen von weniger als 1% zeigt. Damit kann die beschriebene Leiterplatte auch problemlos weiterverarbeitet werden, wobei eine Weiterverarbeitung insbesondere darin bestehen kann, dass die Leiterplatte mit weiteren elektronischen Bauelementen bestückt und/oder in einem Reflow Ofen verlötet wird. Auch kann die beschriebene Leiterplatte mit einer weiteren Leiterplatte verbunden, beispielsweise verklebt, werden, so dass eine Leiterplatte mit mehreren Schichten entsteht. In diesem Zusammenhang bedeutet eine Verwerfung von weniger als 1%, dass eine Verwerfungshöhe der betreffenden Schicht (entlang der z-Achse) im Verhältnis zu einer Länge der betreffenden Schicht (in einer xy-Ebene, welche senkrecht zu der z-Achse ist) kleiner als 1% ist.

Die erfindungsgemäße Leiterplatte kann auf besonders vorteilhafte Weise für so genannte Leistungsmodule verwendet werden, welche mit bzw. bei einer großen elektrischen Leistung arbeiten und bei welchen es naturgemäß aufgrund von nie zu vermeidenden elektrischen Verlusten zu einer großen Wärmeentwicklung kommt. Bei der Herstellung von solchen Leistungsmodulen werden typischerweise mehrere mit Hochleistungsbauteilen bestückte Leiterplatten in geeigneter Weise miteinander verbunden, so dass diese innerhalb eines relativ kleinen Bauraums angeordnet sind und es demzufolge zu einer sehr starken Wärmeentwicklung insbesondere im Inneren dieses Bauraums kommt. Demzufolge ist für solche Anwendungen die erfindungsgemäße Leiterplatte, welche eine besonders hohe thermische Stabilität aufweist, besonders geeignet.

Es wird darauf hingewiesen, dass die beschriebenen Wertebereiche des erfindungsgemäßen dielektrischen Materials eine derzeit ideale Kombination von Elastizitätsmodul und CTE darstellen. Dabei ist nämlich zum einen die thermische Ausdehnung so klein, dass es nur zu sehr kleinen thermischen Verspannungen kommen kann, und zum anderen ist die Steifigkeit des dielektrischen Materials (a) so klein, dass möglicherweise vorhandene geringe thermische Ausdehnungen aufgefangen werden können, und (b) so groß, dass das dielektrische Materials auf gewöhnliche Weise weiterverarbeitet werden kann.

Gemäß einem Ausführungsbeispiel der Erfindung wird die in diesem Dokument beschriebene Leiterplatte mit einem Material gebildet, welches in der EP 2 666 806 A1 beschrieben ist. Dieses Material wird aus einem Fasersubstrat und einer Schicht aus einer unter Wärme aushärtbaren Harzzusammensetzung hergestellt. Diese Schicht enthält eine modifizierte Siloxanverbindung oder eine Verbindung mit einem Grundgerüst aus einer modifizierten Siloxanverbindung.

Die beschriebene metallische Schicht kann insbesondere eine Kupferschicht sein, welche aus einer Kupferfolie resultiert. Bei der Herstellung der beschriebenen Leiterplatte aus einem Schichtverbund bestehend zumindest aus der dielektrischen Schicht und der beschriebenen Metallschicht kann die Kupferfolie im einfachsten Fall über die entsprechende dielektrische Schicht gelegt werden und mit dieser zusammen später zu einem Verbund verpresst werden. Selbstverständlich sind für die beschriebene Leiterplatte auch Schichtaufbauten möglich, welche mehr als eine metallische Schicht und/oder mehr als eine dielektrische Schicht aufweisen.

Unter dem Ausdruck "frei von einer Symmetrieebene" kann insbesondere verstanden werden, dass sich entlang der z-Richtung keine Ebenen findet, die für die Gesamtheit des Schichtenverbundes eine Symmetrieebene darstellt. Es ist jedoch möglich, dass bezüglich lediglich eines Teils bzw. einer Substruktur des Schichtenverbundes (entlang der z-Achse) eine Symmetrieebene existiert. Bevorzugt weist die beschriebene Leiterplatte jedoch auch für einen beliebigen Teil der Leiterplatte keine Symmetrieebene auf.

Unter dem Begriff "Schichtenverbund" ist in diesem Dokument insbesondere eine Folge von Schichten zu verstehen, welche jeweils durch eine bestimmte Dicke und durch ein bestimmtes Material charakterisiert sind. Der Schichtenverbund kann eine beliebige Abfolge von elektrisch leitenden Schichten, elektrisch isolierenden (dielektrischen) Schichten, Schichten mit einer vorbestimmten thermischen Leitfähigkeit und/oder adhäsiven Schichten aufweisen. Dielektrische Schichten können (bis auf eine Schicht) das hier beschriebenen dielektrische Material oder jedes andere bekannte dielektrische Material aufweisen.

Gemäß einem Ausführungsbeispiel der Erfindung weist das dielektrische Material eine Kriecheigenschaft auf, welche durch zumindest eine der folgenden Eigenschaften bestimmt ist: (a) eine plastische Verformbarkeit im Bereich zwischen 0,01% und 10%, insbesondere im Bereich zwischen 0,1% und 5% und weiter insbesondere im Bereich zwischen 0,2% und 2%, und/oder (b) eine viscoelastische Verformbarkeit im Bereich zwischen 0% und 10%, insbesondere im Bereich zwischen 0% und 5% und weiter insbesondere im Bereich zwischen 0% und 3%.

Der Begriff "Verformbarkeit" kann in diesem Dokument insbesondere die Fähigkeit des dielektrischen Materials beschreiben, ohne eine Zerstörung der inneren Struktur (beispielsweise durch das Ausbilden von Hohlräumen) seine Abmessung (entlang einer Raumrichtung) zu ändern. Die genannten Parameterwerte beziehen sich daher auf eine Längenänderung (insbesondere unter Zug) eines Materialstreifens. Es wird davon ausgegangen, dass bei einer solchen Längenänderung das Volumen des betreffenden Materialstreifens zumindest annähernd gleich bleibt. Anschaulich ausgedrückt wird bei einer Dehnung des Materialstreifens entlang seiner Längsrichtung der Materialstreifen (senkrecht zu seiner Längsrichtung) dünner.

Es wird darauf hingewiesen, dass sich die hier angegebenen Parameterwerte für die plastische Verformbarkeit und die viscoelastische Verformbarkeit auf Raumtemperatur (20°C) beziehen.

Es wird ferner darauf hingewiesen, dass die Kriecheigenschaft des beschriebenen dielektrischen Materials zumindest annähernd isotrop ist. Dies bedeutet, dass das Kriechverhalten der dielektrischen Schicht in allen Raumrichtungen zumindest ungefähr gleich ist.

Die beschriebene Kriecheigenschaft des dielektrischen Materials hat den Vorteil, dass bei der Herstellung der Leiterplatte und insbesondere bei einem Verpressen der verschiedenen Leiterplattenschichten das dielektrische Material in ggf. vorhandene Hohlräume hinein erstreckt und darin verbleibt. Dadurch wird die mechanische Formstabilität bei Temperaturschwankungen, welche in diesem Dokument auch als thermische Formstabilität bezeichnet wird, weiter verbessert.

Die hier beschriebene Kriecheigenschaft hat den Effekt, dass während eines Aushärtens des dielektrischen Materials dieses für eine gewisse Zeit noch eine gewisse Verschiebbarkeit aufweist. Es ergibt sich also eine gewisse Relaxationszeit, in welcher das Material elastisch aber insbesondere auch plastisch verformbar bleibt. Innerhalb dieser Relaxationszeit und Kriechzeit sollte insbesondere der Vorgang des Verpressens der verschiedenen Schichten der erfindungsgemäßen Leiterplatte zumindest annähernd vollständig durchgeführt werden.

Die vorstehend beschriebenen Wertebereiche für das Elastizitätsmodul und den CTE stellen in Verbindung mit der hier beschriebenen Kriecheigenschaft eine ideale Kombination für eine sichere und schonende Einbettung der elektronischen Komponente dar. Die hier beschriebene Kriecheigenschaft hat nämlich den Effekt, dass während eines Aushärtens des Materials dieses für eine gewisse Zeit noch eine gewisse Verschiebbarkeit aufweist. Es ergibt sich also eine gewisse Relaxationszeit, in welcher das Material elastisch aber insbesondere auch plastisch verformbar bleibt. Innerhalb dieser Relaxationszeit und Kriechzeit sollte insbesondere der Vorgang des Verpressens der verschiedenen Schichten der erfindungsgemäßen Leiterplatte zumindest annähernd vollständig durchgeführt werden.

Ferner kann sich das beschriebene dielektrische Material auch dadurch auszeichnen, dass es trotz einem hohen elastischen Anteil auch plastisch verformbar bleibt.

Gemäß einem weiteren Ausführungsbeispiel der Erfindung ist das dielektrische Material eine Mischung oder ein Copolymer bestehend aus zumindest einem ersten Material mit einem ersten Elastizitätsmodul E und einem ersten thermischen Ausdehnungskoeffizienten und einem zweiten Material mit einem zweiten Elastizitätsmodul E und einem zweiten thermischen Ausdehnungskoeffizienten. Der erste Elastizitätsmodul ist größer als der zweite Elastizitätsmodul und der erste thermische Ausdehnungskoeffizient ist kleiner als der zweite thermische Ausdehnungskoeffizient.

Anschaulich ausgedrückt ist das erste Material im Vergleich zu dem zweiten Material härter und weist einen kleineren CTE auf. Durch die Wahl eines geeigneten Mischungsverhältnisses oder Copolymerisationsverhältnisses zwischen dem ersten Material und dem zweiten Material kann auf relativ einfache Weise das vorstehend beschriebene dielektrische Material hergestellt werden, welches das gewünschte Elastizitätsmodul E und den gewünschten CTE aufweist.

Gemäß einem weiteren Ausführungsbeispiel der Erfindung weist das erste Material eine erste Glasübergangstemperatur auf und das zweite Material weist eine zweite Glasübergangstemperatur auf.

Durch die Wahl zweier Materialien mit unterschiedlicher Glasübergangstemperatur (Tg) kann durch eine Mischung oder Copolymerisation der beiden Materialien auf besonders einfache Weise das vorstehend beschriebene dielektrische Material hergestellt werden, welches den gewünschten Elastizitätsmodul E und den gewünschten CTE aufweist.

Die erste Tg kann beispielsweise im Bereich zwischen 150°C und 190°C und insbesondere im Bereich zwischen 160°C und 180°C liegen. Bevorzugt ist die erste Tg zumindest annähernd 170°C. Die zweite Tg kann beispielsweise im Bereich zwischen 0°C und 70°C und insbesondere im Bereich zwischen 10°C und 30°C liegen. Bevorzugt liegt die erste Tg zumindest annähernd bei Raumtemperatur (20°C).

Gemäß einem weiteren Ausführungsbeispiel der Erfindung weist das erste Material ein Harz und einen sich darin befindlichen harten Füllstoff auf.

Das Harz kann beispielsweise ein Phenol-Harz oder ein Epoxidharz, beispielsweise ein bromiertes Bisphenol A Epoxidharz sein. Der Füllstoff kann beispielsweise Glas, Quarz, und/oder Aluminiumhydroxid sein. Mit einem solchen Füllstoff kann auf besonders einfache Weise ein geringer Wert für den CTE des ersten Materials eingestellt werden. Bevorzugt kann der Füllstoff kleine SiO2 Kugeln oder Partikel aufweisen, welche von dem Harz ummantelt sind.

Gemäß einem weiteren Ausführungsbeispiel der Erfindung weist das zweite Material ein thermisch aushärtbares Harz auf, welches mit einem weichmachenden Stoff verbunden ist. Dies kann den Vorteil haben, dass mittels einer geeigneten Dosierung des weichmachenden Stoffes die gewünschte Härte bzw. Weichheit des dielektrischen Materials auf einfache und genaue Weise eingestellt werden kann.

Der weichmachende Stoff kann z. B. ein aliphatischer Polyester oder Polyether sein, wobei bei der Polyaddition ein elastisches Blockcopolymer entsteht.

Gemäß einem weiteren Ausführungsbeispiel der Erfindung liegt der Wert für das Elastizitätsmodul E im Bereich zwischen 2 und 7 GPa und insbesondere im Bereich zwischen 3 und 5 GPa.

Mit einem Elastizitätsmodul in diesen Bereichen kann ein besonders guter Kompromiss zwischen (a) einer möglichst spannungsfreien Einbettung der elektronischen Komponente und (b) einer guten Verarbeitbarkeit der dielektrischen Schicht erreicht werden.

Gemäß einem weiteren Ausführungsbeispiel der Erfindung liegt der thermische Ausdehnungskoeffizient im Bereich zwischen 3 und 10 ppm/K und insbesondere im Bereich zwischen 5 und 8 ppm/K.

Gemäß einer derzeit als am besten angesehenen Ausführungsform beträgt der CTE des dielektrischen Materials zumindest annähernd 6 ppm/K. Damit ist der CTE des dielektrischen Materials ungefähr gleich wie der CTE von elektronischen Bauelementen, welche demzufolge besonders spannungsfrei an der Leiterplatte angebracht oder in die Leiterplatte eingebettet werden können. In diesem Zusammenhang wird darauf hingewiesen, dass der CTE von elektronischen Bauelementen im Wesentlichen durch den CTE von Silizium bestimmt ist, welches einen CTE Wert von ungefähr 3 ppm/K aufweist.

Gemäß einem weiteren Ausführungsbeispiel der Erfindung weist der Schichtenverbund entlang der z-Achse eine Asymmetrie bezüglich der Anzahl der Schichten auf.

Eine Asymmetrie bezüglich der Anzahl der Schichten des Schichtenverbundes kann insbesondere bedeuten, dass die oberhalb einer zur z-Achse senkrechten Ebene eine erste Anzahl von Schichten und unterhalb dieser Ebenen eine zweite Anzahl von Schichten vorhanden ist. Diese Ebene kann in Bezug auf die Gesamtdicke des Schichtenverbundes eine Mittelebene sein.

Gemäß einem weiteren Ausführungsbeispiel der Erfindung weist der Schichtenverbund entlang der z-Achse eine Asymmetrie bezüglich der Dicken einzelnen Schichten auf.

Eine Asymmetrie bezüglich der Dicken der Schichten des Schichtenverbundes kann insbesondere bedeuten, dass zumindest eine Schichtdicke oberhalb einer zur z-Achse senkrechten Ebene eine unterschiedlich Dicke aufweist als eine korrespondierende Schicht auf der Unterseite dieser Ebene. Die "Korrespondenz" der beiden Schichten kann insbesondere darin bestehen, dass sie das gleiche Material aufweisen. Die Anzahl der Schichten oberhalb dieser Ebene kann gleich oder unterschiedlich sein zu der Anzahl der Schichten unterhalb dieser Ebene.

Gemäß einem weiteren Ausführungsbeispiel der Erfindung weist der Schichtenverbund entlang der z-Achse eine Asymmetrie bezüglich der Materialien einzelnen Schichten auf.

Eine Asymmetrie bezüglich der Materialien kann insbesondere bedeuten, dass die oberhalb einer zur z-Achse senkrechten Ebene andere Materialien oder Materialkombinationen für die jeweiligen Schichten verwendet werden. Hinsichtlich der Schichtdicken und/oder der Anzahl der Schichten könnte bei sehr speziellen Ausführungsformen diese Ebene sogar eine Symmetrieebene sein.

Es wird darauf hingewiesen, dass auch eine beliebige Kombination der vorstehend genannten Asymmetrien gegeben sein kann.

Gemäß einem weiteren Ausführungsbeispiel der Erfindung weist die Leiterplatte ferner eine Komponente und insbesondere eine elektronische Komponente auf, welche in der dielektrischen Schicht und/oder in einer dielektrischen Kern-Schicht der Leiterplatte eingebettet ist.

Das vorstehend beschriebene formstabile dielektrische Material der erfindungsgemäßen Leiterplatte kann nicht nur zur Ausbildung eines asymmetrischen Schichtenaufbaus verwendet werden. Vielmehr wird gemäß dem hier beschriebenen Ausführungsbeispiel auch noch eine Komponente in dieses Material eingebettet, welches auch bei vergleichsweise starken Temperaturänderungen keinen oder nur wenig mechanischen Stress erzeugt. In Bezug auf eine Leiterplatte bzw. einen Leiterplattennutzen kann eine Komponente oder können zwei oder auch mehr als zwei Komponenten eingebettet sein.

Aufgrund der geringen thermisch induzierten internen mechanischen Belastungen werden im Falle einer elektronischen Komponente auch die (internen) Anschlüsse der eingebetteten Komponente nur einem geringen mechanischen Stress ausgesetzt. Ferner werden auch die Oberflächen der eingebetteten elektronischen Komponente, welche mit dem dielektrischen Prepreg Material in Kontakt stehen, durch Temperaturänderungen nur wenig mechanisch belastet, so dass die elektronische Komponente auf mechanisch schonende Weise in der Leiterplatte eingebettet ist.

Aufgrund der Möglichkeit eine elektronische Komponente in zumindest eine der beiden dielektrischen Schichten stressarm einzubetten, kann die erfindungsgemäße Leiterplatte auch mit vergleichsweise großen elektronischen Komponenten versehen werden, welche beispielsweise eine Fläche von 10mm x 10mm haben. Außerdem führen die geringen thermisch induzierten mechanischen Belastungen auch zu einer Reduktion des mechanischen Stresses auf elektrische Verbindungen zu und/oder von der elektronischen Komponente, wenn die erfindungsgemäße Leiterplatte im Rahmen einer weiteren Elektronikfertigung mit anderen herkömmlichen Leiterplatten beispielsweise zu einer mehrlagigen Leiterplatte verbunden wird.

Unter dem Begriff "eingebettet" kann in diesem Dokument verstanden werden, dass die Komponente von mehreren Seiten von dem betreffenden Material bzw. der betreffenden Schicht umgeben ist. Dabei kann die betreffende Seite der Komponente vollständig oder lediglich teilweise von dem betreffenden Material bzw. der betreffenden Schicht bedeckt sein. Ein eingebetteter Zustand der Komponente kann im Fall einer quaderförmigen Geometrie der Komponente (d.h. eine Komponente mit insgesamt 6 Seitenflächen) insbesondere dann vorliegen, (a) wenn die untere Seitenfläche und die vier Seitenflächen von dem Einbettungsmaterial bedeckt sind, (b) wenn lediglich die vier Seitenflächen von dem Einbettungsmaterial bedeckt sind, (c) wenn die untere Seitenfläche vollständig und die vier Seitenflächen lediglich teilweise von dem Einbettungsmaterial bedeckt sind, oder (d) wenn lediglich die vier Seitenflächen lediglich teilweise von dem Einbettungsmaterial bedeckt sind.

Wie bereits vorstehend angemerkt, kann die Komponente eine elektronische Komponente sein, welche wiederum jedes beliebige aktive oder passive elektronische Bauelement sein kann. In diesem Zusammenhang kann die elektronische Komponente eine weitere Leiterplatte, ein Modul (eine vollständig oder teilweise mit Bauelementen bestückte Leiterplatte), eine Batterie und/oder eine MEMS Struktur sein. Die Komponente kann jedoch auch eine "nicht-elektronische" Komponente, beispielsweise ein Kühlelement, sein, welches insbesondere aus einem metallischen Material besteht.

Gemäß einem weiteren Ausführungsbeispiel der Erfindung ist die Komponente in der dielektrischen Schicht eingebettet.

Falls die beschriebene Leiterplatte zusätzlich die vorstehend beschriebene dielektrische Kern-Schicht aufweist, befindet sich die Komponente bevorzugt ausschließlich in der dielektrischen Schicht.

Es wird darauf hingewiesen, dass die Verwendung der vorstehend beschriebenen dielektrischen Kern-Schicht für die in diesem Dokument beschriebene Leiterplatte optional ist. Auch wenn die dielektrische Kern-Schicht der beschriebenen Leiterplatte eine gewisse mechanische Festigkeit verleiht, was in vielen Anwendungen von Vorteil ist, so kann eine erfindungsgemäße Leiterplatte insbesondere dann auch ohne dielektrische Kern-Schicht aufgebaut werden, wenn es sich um eine flexible Leiterplatte handeln soll.

Gemäß einem weiteren Ausführungsbeispiel der Erfindung weist die Leiterplatte ferner die dielektrische Kern-Schicht auf, welche flächig an der metallischen Schicht und/oder an der dielektrischen Schicht angebracht ist. Die Komponente ist in der dielektrischen Kern-Schicht eingebettet und die dielektrische Schicht ist oberhalb oder unterhalb der dielektrischen Kern-Schicht sowie der eingebetteten Komponente angeordnet.

Bevorzugt ist die Komponente ausschließlich in der dielektrischen Kern-Schicht eingebettet. Außerdem kann die dielektrische Kern-Schicht zwischen zwei dielektrischen Schichten angeordnet sein. Weiter bevorzugt befindet sich die dielektrische Schicht unmittelbar auf der dielektrischen Kern-Schicht bzw. der Komponente.

Anschaulich ausgedrückt stellt die dielektrische Schicht eine Deckelstruktur für die Komponente dar. Damit befindet sich die dielektrische Schicht, welche für die Spannungsfreiheit in der beschriebenen Leiterplatte in besonderem Maße verantwortlich ist, unmittelbar an der Komponente, deren Einbettung damit zumindest annähernd perfekt spannungsfrei ist.

In diesem Zusammenhang erscheinen derzeit insbesondere Schichtaufbauten interessant zu sein, welche durch eine Kombination einer relativ steifen dielektrischen Kern-Schicht, welche einem geringen Schrumpf aufweist, mit der in diesem Dokument beschriebenen dielektrischen Schicht entstehen. Hier kann nämlich neben der stressarmen Einbettung der Komponente auch eine gute Dimensionsstabilität gewährleistet werden, welche insbesondere für einen weiteren Aufbau hin zu einer qualitativ hochwertigen Mehrfachschicht-Leiterplatte (Multilayer Leiterplatte) wichtig ist.

Die hier beschriebene Steifigkeit der dielektrischen Kern-Schicht kann beispielsweise dadurch erreicht werden, dass für die dielektrische Kern-Schicht ein aushärtbares Material verwendet wird, welches im Verlauf der Herstellung der beschriebenen Leiterplatte ausgehärtet wird.

Gemäß einem weiteren Ausführungsbeispiel der Erfindung ist die Komponente in der dielektrischen Kern-Schicht eingeklebt. Dies ermöglicht auf vorteilhafte Weise eine besonders stabile Einbettung der Komponente in der dielektrischen Kern-Schicht.

Bevorzugt ist in dieser Ausführungsform die dielektrische Kern-Schicht ein steifer Kern, welcher auf beiden flächigen Seiten mit einer dielektrischen Schicht versehen ist. Das Anbringen der beiden dielektrischen Schichten kann in bekannter Weise mittels laminieren erfolgen, um einen stabilen Schichtverbund mit der eingebetteten elektronischen Komponente zu erzeugen.

Gemäß einem weiteren Ausführungsbeispiel der Erfindung weist die dielektrische Kern-Schicht ein dielektrisches Kern-Material auf, welches entlang der x-Achse und entlang der y-Achse einen thermischen Ausdehnungskoeffizienten von 0 bis 11 ppm/K, insbesondere von 2 bis 10 ppm/K und weiter bevorzugt von 3 bis 9 ppm/K hat.

Dies hat den Vorteil, dass der Kern der Leiterplatte aus einem Material besteht, welches einen CTE in der Größenordnung von dem CTE von der eingebetteten Komponente bzw. von Si aufweist. Das Kern-Material kann, insbesondere dann, wenn es sich um ein ausgehärtetes Kern-Material handelt, einen hohen Elastizitätsmodul E haben, um Kräfte, welche beim Vorgang eines Laminierens entstehen, aufnehmen zu können und damit nicht an die eingebettete Komponente weiterzuleiten. In einem Spalt zwischen der eingebetteten Komponente und dem Kern-Material kann sich das vorstehend beschriebene dielektrische Material mit seinem vergleichsweise niedrigen Elastizitätsmodul E befinden. Aufgrund dieses niedrigen Elastizitätsmoduls E kann es auf vorteilhafte Weise Spannungen ausgleichen.

In diesem Zusammenhang wird darauf hingewiesen, dass durch eine thermische Anpassung der Ausdehnungskoeffizienten des dielektrischen Kern-Materials und der elektronischen Komponente folgende vorteilhafte Effekte erzielt werden können:
(A) Die Betriebszuverlässigkeit einer auf der Leiterplatte aufgebauten elektronischen Schaltung, welche optional die eingebettete elektronische Komponente enthalten kann, kann im Vergleich zu bekannten Leiterplattenaufbauten insbesondere bei schwankenden thermischen Bedingungen verbessert werden.
(B) Auch bei thermischen Nachfolgeprozessen werden keine oder nur zu vernachlässigende mechanische Spannungen in den Schichtverbund der beschriebenen Leiterplatte eingebracht. Dadurch entsteht ein Verbund mit geringer Verwerfung. Dies gilt selbst bei einem Flächenanteil der eingebetteten Komponente(n) im Vergleich zu der Gesamtfläche der beschriebenen Leiterplatte von mehr als 30%.

Gemäß einem weiteren Ausführungsbeispiel der Erfindung ist die Gesamtdicke des Schichtenverbundes kleiner als ungefähr 200 µm, insbesondere kleiner als ungefähr 190 µm und weiter insbesondere kleiner als ungefähr 180 µm. In von den Erfindern bereits realisierten Ausführungsbeispielen hat der Schichtenverbund sogar eine Gesamtdicke von lediglich 170 µm bzw. von 150 µm und ist damit dünner als ungefähr 175 µm.

Es wird darauf hingewiesen, dass die erreichbaren minimalen Dicken der Leiterplatten von der Höhe der eingebetteten Komponente abhängen. In diesem Zusammenhang beziehen sich die vorstehend genannten Dicken auf eine eingebettete Komponente mit einer Höhe von 150 µm.

Es wird ferner darauf hingewiesen, dass die Dicke des Schichtenverbundes gleich sein kann wie die Dicke der gesamten Leiterplatte. Mit der hier beschriebenen Kombination aus dielektrischem Material und asymmetrischen Aufbau können bei einer eingebetteten Komponente mit einer Dicke von 150 µm somit stabile Leiterplatten bzw. Leiterplattenstrukturen aufgebaut werden, welche um bis zu 20% dünner sind als herkömmliche Leiterplatten mit einer derartigen eingebetteten Komponente.

Die Leiterplatte kann lediglich auf einer Seite, das heißt entweder oberhalb oder unterhalb der eingebetteten elektronischen Komponente eine mechanische Stützstruktur aufweisen. Es wird darauf hingewiesen, dass eine solche Struktur nur unter Verwendung der in diesem Dokument beschriebenen dielektrischen Schicht möglich ist, weil nur diese die für einen solchen Aufbau erforderliche Elastizität und thermische Ausdehnung aufweist.

Gemäß einem weiteren Ausführungsbeispiel der Erfindung ist die dielektrische Schicht eine dielektrische Prepreg-Schicht ist /oder das dielektrische Material ist ein dielektrisches Prepreg-Material.

Unter dem Begriff "Prepreg-Schicht" kann in diesem Dokument ein vorgefertigtes dielektrisches schichtförmige Substrat verstanden werden, welches aus einem "Prepreg-Material" aufgebaut ist. In diesem Zusammenhang ist Prepreg die englische Kurzform für "preimpregnated fibers", was auf Deutsch "vorimprägnierte Fasern" bedeutet. Ein Prepreg ist ein Halbzeug, bestehend aus Lang- oder Endlosfasern und einer vorgetrockneten bzw. vorgehärteten, jedoch noch nicht polymerisierten duroplastischen Kunststoffmatrix, das v. a. im Leichtbau Verwendung findet. Die enthaltenen Fasern können als reine unidirektionale Schicht, als Gewebe oder als Gelege vorliegen.

Gemäß einem weiteren Aspekt der Erfindung wird ein Verfahren zum Herstellen einer Leiterplatte und insbesondere einer vorstehend beschriebenen Leiterplatte angegeben. Dieses Verfahren weist auf Aufbauen eines übergeordneten Schichtenverbundes mit (a) zumindest einer dielektrischen Schicht, welche (a1) parallel zu einer xy-Ebene, die durch eine x-Achse und eine dazu senkrechte y-Achse aufgespannt ist, eine flächige Ausdehnung aufweist und (a2) entlang einer z-Achse, welche senkrecht zu der x-Achse und zu der y-Achse ist, eine Schichtdicke aufweist; und (b) zumindest einer metallischen Schicht, welche flächig an der dielektrischen Schicht angebracht ist. Der Schichtenverbund ist entlang der z-Achse frei von einer Symmetrieebene, welche parallel zu der xy-Ebene orientiert ist, und die dielektrische Schicht weist ein dielektrisches Material auf. Das dielektrische Material hat (i) ein Elastizitätsmodul E im Bereich zwischen 1 und 20 GPa und (ii) entlang der x-Achse und entlang der y-Achse einen thermischen Ausdehnungskoeffizienten im Bereich zwischen 0 und 17 ppm/K.

Auch dem beschriebenen Verfahren liegt die Erkenntnis zugrunde, dass durch die besondere Eigenschaften des genannten dielektrischen Materials Leiterplatten mit einem asymmetrischen Schichtenaufbau realisiert werden können, welche bei größeren Temperaturschwankungen auch dann eine hohe mechanische Formstabilität aufweisen, wenn der asymmetrische Schichtenaufbau lediglich eine geringe Schichtdicke aufweist.

Gemäß einem Ausführungsbeispiel der Erfindung weist das Verfahren ferner auf (a) ein Ausbilden einer Ausnehmung in der dielektrischen Schicht und/oder in einer dielektrischen Kern-Schicht; und (b) ein Einbringen einer elektronischen Komponente in die Ausnehmung.

In die Ausnehmung kann ferner ein adhäsives Material eingebracht werden. Dieses kann ein niederviskoser Klebstoff sein, welcher die Eigenschaft hat, eine möglichst feste Verbindung sowohl (a) mit dem Material der elektronischen Komponente als auch (b) mit der dielektrischen Schicht und/oder mit der dielektrischen Kern-Schicht einzugehen. Dadurch kann eine besonders hohe mechanische Stabilität der Einbettung der elektronischen Komponente erreicht werden.

Abhängig von der Verpackung der elektronischen Komponente sollte der Klebstoff derart beschaffen sein, dass er eine gute Verbindung zu einem Halbleitermaterial, insbesondere Silizium, (falls es sich bei der elektronischen Komponente um einen ungehäusten Chip bzw. Bare Die handelt) oder zu einem typischen Verpackungsmaterial eines Bauelements hat (falls es sich bei der elektronischen Komponente um einen gehäusten Chip handelt).

Gemäß einem weiteren Ausführungsbeispiel der Erfindung ist die Ausnehmung größer als die elektronische Komponente, so dass nach einem Einbringen der elektronischen Komponente in die Ausnehmung ein Hohlraum verbleibt.

In diesen Hohlraum kann im Laufe des weiteren Prozessierens der Leiterplatte das dielektrische Material eindringen, so dass die eingebettete elektronische Komponente von verschiedenen Seiten mit dem dielektrischen Material umgeben ist. Dadurch ergibt sich auf vorteilhafte Weise eine besonders stressfreie Einbettung der elektronischen Komponente in die Leiterplatte.

Gemäß einem weiteren Ausführungsbeispiel der Erfindung weist das Verfahren ferner auf, (a) falls die elektronische Komponente in der dielektrischen Schicht eingebracht ist, ein Aufbringen einer weiteren dielektrischen Schicht auf die dielektrische Schicht und die elektronischen Komponente, wobei die weitere dielektrische Schicht die gleichen Eigenschaften hat wie die dielektrische Schicht; und (c) falls die elektronische Komponente in der dielektrischen Kern-Schicht eingebettet ist, ein Aufbringen der dielektrischen Schicht auf die dielektrische Kern-Schicht und die elektronische Komponente.

Anschaulich ausgedrückt stellt gemäß dem hier beschriebenen Ausführungsbeispiel die aufgebrachte weitere dielektrische Schicht bzw. die aufgebrachte dielektrische Schicht eine Deckelstruktur dar, welche für eine gute mechanische Stabilität bei einer weiterhin stressfreien Einbettung der elektronischen Komponente sorgt. Dies gilt insbesondere auch bei Temperaturschwankungen, die während der weiteren Herstellung einer elektronischen Baugruppe auf der beschriebenen Leiterplatte und/oder während eines Betriebs der auf der beschriebenen Leiterplatte aufgebauten elektronischen Baugruppe auftreten können.

Gemäß einem weiteren Ausführungsbeispiel der Erfindung weist das Verfahren ferner ein Ausbilden einer metallischen Schicht an der dielektrischen Schicht auf.

Die metallische Schicht kann insbesondere eine Kupferschicht sein, welche später in geeigneter Weise strukturiert werden kann, um Leiterbahnen für (in Bezug zu der Leiterplatte externe) elektronische Bauelemente einer auf der Leiterplatte bestückten elektronischen Baugruppe bereitzustellen. Ferner können solche Leiterbahnen auch dazu verwendet werden, die eingebettete (in Bezug zu der Leiterplatte interne) elektronische Komponente zu kontaktieren. Dafür können in bekannter Weise auch Vias verwendet werden, welche insbesondere in der die elektronische Komponente bedeckenden dielektrischen Schicht beispielsweise mittels Laserbohrens ausgebildet und nachfolgend in bekannter Weise metallisiert werden können, um eine Kontaktierung senkrecht zu der Ebene der Schichten der Leiterplatte zu realisieren.

Gemäß einem weiteren Ausführungsbeispiel der Erfindung weist das Verfahren ferner ein Verpressen sämtlicher Schichten der Leiterplatte auf.

Durch ein geeignetes Verpressen kann aus dem zuvor vergleichsweise losen Schichtenaufbau der Leiterplatte auf einfache Weise ein mechanisch stabiler asymmetrischer Schichtenverbund entstehen. Es wird jedoch darauf hingewiesen, dass insbesondere in Abhängigkeit der gesamten Dicke des Schichtenverbundes die Leiterplatte noch eine gewisse (gewünschte) Flexibilität aufweisen kann.

Gemäß einem weiteren Ausführungsbeispiel der Erfindung wird ein Verfahren zum Herstellen einer Leiterplattenstruktur beschrieben. Das beschriebene Verfahren weist auf (a) Herstellen einer ersten Leiterplatte mit einem Verfahren des vorstehend beschriebenen Typs; (b) Herstellen einer zweiten Leiterplatte mit einem Verfahren des vorstehend beschriebenen Typs; und (c) Zusammenfügen der ersten Leiterplatte und der zweiten Leiterplatte, so dass die resultierende Leiterplattenstruktur zumindest eine Dicke aufweist, welche sich aus der Summe von einer ersten Dicke der ersten Leiterplatte und einer zweiten Dicke der zweiten Leiterplatte ergibt.

Dem beschriebenen Verfahren liegt die Erkenntnis zugrunde, dass die erste Leiterplatte und/oder die zweite Leiterplatte auch ein Halbzeug für die Herstellung der beschriebenen (größeren) Leiterplattenstruktur sein können.

Die resultierende Leiterplattenstruktur kann insbesondere eine asymmetrische Gesamtschichtenfolge aufweisen, welche aufgrund der vorstehend beschriebenen herausragenden mechanischen Eigenschaften der dielektrischen Schichten trotz des asymmetrischen Aufbaus eine hohe Formstabilität auch bei größeren Temperaturschwankungen aufweist.

Gemäß einem weiteren Ausführungsbeispiel der Erfindung weist die resultierende Leiterplattenstruktur eine symmetrische Gesamtschichtenfolge auf. Dies kann den Vorteil haben, dass die Formstabilität der symmetrischen Leiterplattenstruktur insbesondere bei starken Temperaturschwankungen im Vergleich zu der Formstabilität der beiden asymmetrischen Leiterplatten weiter verbessert wird.

Gemäß einem weiteren Ausführungsbeispiel der Erfindung wird ein Verfahren zum Herstellen von zwei prozessierten Leiterplatten beschrieben. Das Verfahren weist auf (a) Aufbauen eines Schichtenverbundes mit einer ersten (asymmetrischen) Leiterplatte des vorstehend beschriebenen Typs, einer zweiten (asymmetrischen) Leiterplatte des vorstehend beschriebenen Typs und einer Ablöseschicht, welche zwischen der ersten Leiterplatte und der zweiten Leiterplatte angeordnet ist; (b) Prozessieren des gesamten Schichtenverbundes; und (c) Auftrennen der Schichtenverbundes an der Ablöseschicht, so dass eine erste prozessierte Leiterplatte und eine zweite prozessierte Leiterplatte mit jeweils einem asymmetrischen Schichtaufbau entstehen.

Dem beschriebenen Verfahren liegt die Erkenntnis zu Grunde, dass ein symmetrisch aufgebauter Schichtenverbund mit all seinen Vorteilen bei dessen Herstellung und Prozessierung verwendet werden kann, um mittels eines geeigneten Auftrennens an einer Ablöseschicht zwei asymmetrische Leiterplatten herzustellen, welche die vorstehend beschriebenen Vorteile, insbesondere die besonders geringe Gesamtdicke, aufweisen.

Bei dem hier beschriebenen Verfahren stellen die zwei zumindest teilweise unprozessierten Leiterplatten, welche zu dem Schichtenverbund aufgebaut werden, ein Halbzeug dar. Die Verbindung dieser beiden Halbzeuge, welche jeweils zumindest eine der vorstehend beschriebenen dielektrischen Schichten aufweisen, erfolgt bevorzugt an ausgewählten Stellen mittels eines Verpressens. Die ausgewählten Stellen können insbesondere durch Punkte gegeben sein, welche bei der weiteren Prozessführung nicht mehr benötigt bzw. von der weiteren Prozessführung nicht mehr beeinflusst werden.

Nach dem Verpressen können in vorteilhafter Weise beide Halbzeuge gleichzeitig bearbeitet werden, wobei auf die Vorteile eines asymmetrischen Aufbaus nicht verzichtet werden muss. Diese Bearbeitung bzw. Prozessierung kann alle notwendigen Arbeitsschritte bei einer Leiterplattenfertigung umfassen. Die Arbeitsschritte können beispielsweise ein weiteres Aufbauen von Schichten, ein Bohren von Vias, ein Fotoätzen, etc. umfassen. Durch ein Ablösen der prozessierten ersten Leiterplatte von der prozessierten zweiten Leiterplatte an der Ablöseschicht erhält man auf einfache Weise zwei asymmetrische Leiterplatten, die in einem einzigen Prozessablauf hergestellt wurden. Nachfolgend können an den beiden einzelnen prozessierten asymmetrischen Leiterplatten letzte Finishing-Prozesse wie beispielsweise eine Abscheiden von Goldschichten, ein Konturfräsen, etc. erfolgen.

Gemäß einem Ausführungsbeispiel der Erfindung weist der aufgebaute Schichtenverbund entlang der z-Achse eine Symmetrieebene auf, welche parallel zu der xy-Ebene orientiert ist.

Gemäß einem weiteren Ausführungsbeispiel der Erfindung weist die Ablöseschicht ein druckfähiges Haftreduzierungsmaterial auf, welches mittels eines Druckverfahrens und insbesondere mittels eines Siebdruckverfahrens auf zumindest einen Teilbereich der ersten Leiterplatte oder auf zumindest einen Teilbereich der zweiten Leiterplatte transferiert wird. Ein solches Haftreduzierungsmaterial, welches auch als Haftverhinderungsmaterial bezeichnet wird, ist beispielsweise in der WO 2010/085830 A1 beschrieben und setzt sich aus einem Haftverhinderungsadditiv, einem Bindemittel und einem Lösungsmittel zusammen. Ein solches Haftverhinderungsmittel kann vor einem Laminieren bzw. einem Verpressen des betreffenden Schichtenverbundes strukturiert auf die gewünschte Oberfläche der betreffenden Leiterplatte gedruckt werden und erlaubt nach dem Laminieren und einem Durchtrennen der seitlichen Begrenzung des strukturierten Bereichs eine Trennung der beiden (Teile der) Leiterplatten innerhalb des strukturierten Bereichs. Eine solche Vorgangsweise zum Trennen ist deutlich einfacher und kostengünstiger durchzuführen als beispielsweise eine andere Vorgehensweise, bei der anstelle des Haftreduzierungsmaterial vor dem Vorgang des Laminierens bzw. Verpressens zwischen die beiden Leiterplatten eine Trennfolie (z.B. eine Teflonfolie).

Es wird darauf hingewiesen, dass Ausführungsformen der Erfindung mit Bezug auf unterschiedliche Erfindungsgegenstände beschrieben wurden. Insbesondere sind einige Ausführungsformen der Erfindung mit Vorrichtungsansprüchen und andere Ausführungsformen der Erfindung mit Verfahrensansprüchen beschrieben. Dem Fachmann wird jedoch bei der Lektüre dieser Anmeldung sofort klar werden, dass, sofern nicht explizit anders angegeben, zusätzlich zu einer Kombination von Merkmalen, die zu einem Typ von Erfindungsgegenstand gehören, auch eine beliebige Kombination von Merkmalen möglich ist, die zu unterschiedlichen Typen von Erfindungsgegenständen gehören.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.

### Kurze Beschreibung der Zeichnung

Figuren 1A, 1B und 1C zeigen verschiedene asymmetrische Leiterplatten, welche jeweils eine eingebettete elektronische Komponente aufweisen.
Figuren 2A, 2B und 2C zeigen in einer Querschnittsdarstellung die Herstellung einer Leiterplatte mit zwei eingebetteten elektronischen Komponenten, welche zu Beginn der Herstellung auf einer Sandwichstruktur aufgebracht sind, welche zwischen zwei metallischen Schichten eine dielektrische Kern-Schicht aufweist.
Figuren 3A, 3B und 3C zeigen in einer Querschnittsdarstellung die Herstellung einer Leiterplatte gemäß einem dritten Ausführungsbeispiel unter Verwendung eines temporären Trägers.
Figuren 4A, 4B und 4C illustrieren ein Reduzieren der Dicke einer mit einer eingebetteten elektronischen Komponente hergestellten Leiterplatte bei Verwenden des in diesem Dokument beschriebenen Materials.
Figuren 5A, 5B und 5C illustrieren die Herstellung einer symmetrischen Leiterplattenstruktur mit zwei Halbzeugen, welche jeweils eine asymmetrische Leiterplatte sind.

### Detaillierte Beschreibung

Es wird darauf hingewiesen, dass in der folgenden detaillierten Beschreibung Merkmale bzw. Komponenten von unterschiedlichen Ausführungsformen, die mit den entsprechenden Merkmalen bzw. Komponenten von einer anderen Ausführungsform nach gleich oder zumindest funktionsgleich sind, mit den gleichen Bezugszeichen oder mit einem Bezugszeichen versehen sind, welches sich von dem Bezugszeichen der gleichen oder zumindest funktionsgleichen Merkmale bzw. Komponenten lediglich in der ersten Ziffer unterscheidet. Zur Vermeidung von unnötigen Wiederholungen werden bereits anhand einer vorher beschriebenen Ausführungsform erläuterte Merkmale bzw. Komponenten an späterer Stelle nicht mehr im Detail erläutert.

Ferner wird darauf hingewiesen, dass die nachfolgend beschriebenen Ausführungsformen lediglich eine beschränkte Auswahl an möglichen Ausführungsvarianten der Erfindung darstellen. Insbesondere ist es möglich, die Merkmale einzelner Ausführungsformen in geeigneter Weise miteinander zu kombinieren, so dass für den Fachmann mit den hier explizit dargestellten Ausführungsvarianten eine Vielzahl von verschiedenen Ausführungsformen als offensichtlich offenbart anzusehen sind.

Außerdem wird darauf hingewiesen, dass raumbezogene Begriffe, wie beispielsweise "vorne" und "hinten", "oben" und "unten", "links" und "rechts", etc. verwendet werden, um die Beziehung eines Elements zu einem anderen Element oder zu anderen Elementen zu beschreiben, wie in den Figuren veranschaulicht. Demnach können die raumbezogenen Begriffe für Ausrichtungen gelten, welche sich von den Ausrichtungen unterscheiden, die in den Figuren dargestellt sind. Es versteht sich jedoch von selbst, dass sich alle solchen raumbezogenen Begriffe der Einfachheit der Beschreibung halber auf die in den Zeichnungen dargestellten Ausrichtungen beziehen und nicht unbedingt einschränkend sind, da die jeweils dargestellte Vorrichtung, Komponente etc., wenn sie in Verwendung ist, Ausrichtungen annehmen kann, die von den in der Zeichnung dargestellten Ausrichtungen verschieden sein können.

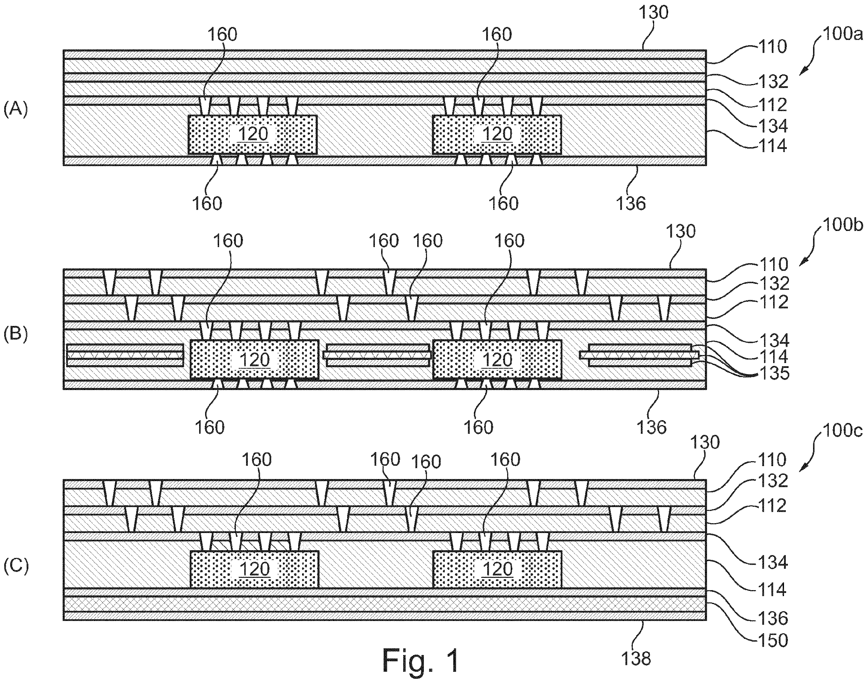

Die Figuren 1A, 1B und 1C zeigen verschiedene asymmetrische Leiterplatten 100a, 100b und 100c, welche jeweils eine eingebettete elektronische Komponente 120 aufweisen.

Die Leiterplatte 100a weist eine Schichtenfolge auf, welche entlang einer vertikalen z-Achse jeweils abwechselnd eine metallische Schicht 130, eine dielektrische Schicht 110, eine metallische Schicht 132, eine dielektrische Schicht 112, eine metallische Schicht 134, eine dielektrische Schicht 114 sowie eine metallische Schicht 136 aufweist. Gemäß dem hier dargestellten Ausführungsbeispiel sind die metallischen Schichten 130, 132, 134 und 136 zumindest vor einem Verpressen der Schichtenfolge Metallfolien, welche das Material Kupfer aufweisen oder in bekannter Weise aus Kupfer bestehen.

Gemäß dem hier dargestellten Ausführungsbeispiel haben sämtliche dielektrische Teilschichten 110, 112 und 114 die in diesem Dokument vorstehend beschriebenen Eigenschaften hinsichtlich der Elastizität (das Elastizitätsmodul E liegt im Bereich zwischen 1 und 20 GPa) und der thermischen Ausdehnung (der thermische Ausdehnungskoeffizient CTE liegt im Bereich zwischen 0 und 17 ppm/K) haben.

Wie aus Figur 1A ersichtlich, weist die dielektrische Schicht 114 im Vergleich zu den anderen dielektrischen Schichten 110 und 112 eine größere Schichtdicke auf. Ferner sind in der dielektrischen Schicht 114 zwei elektronische Komponenten 120 eingebettet. Obwohl gemäß dem hier dargestellten Ausführungsbeispiel die elektronischen Komponenten 120 nicht mittig in der dielektrischen Schicht 114 angeordnet sind, so sind sie doch, wie aus Figur 1A ersichtlich, vollständig von dem entsprechenden dielektrischen Material umgeben. Aufgrund der vorstehend erläuterten mechanischen und thermischen Eigenschaften des dielektrischen Materials sind die elektronischen Komponenten 120, welche aktive Bauelemente, passive Bauelemente und insbesondere ein RFID Bauelement sein können, auf besonders schonende Weise in die Leiterplatte 100a eingebettet.

Es wird darauf hingewiesen, dass die Leiterplatte 100a nach deren Herstellung insbesondere mittels eines Verpressens auch in mehrere einzelne Leiterplatten aufgeteilt bzw. vereinzelt werden kann, so dass beispielsweise in jeder einzelnen Leiterplatte lediglich eine einzige elektronische Komponente 120 eingebettet ist.

Es wird ferner darauf hingewiesen, dass die elektronischen Komponenten 120 sog. Bare Dies bzw. ungehäuste Chips sein können. Alternativ können die elektronischen Komponenten 120 auch gehäuste elektronische Bauelemente sein, welche an zumindest einer ihrer Außenseiten in Figur 1A nicht dargestellte metallische Kontaktstrukturen bzw. Kontaktpads aufweisen.

Zur elektrischen Kontaktierung der elektronischen Komponenten 120 werden gemäß dem hier dargestellten Ausführungsbeispiel in bekannter Weise Vias 160 verwendet. Diese können beispielsweise mittels Laserbohrens ausgebildet werden. Gemäß dem hier dargestellten Ausführungsbeispiel erstrecken sich diese Vias 160 sowohl von oben als auch von unten bis hin zu den beiden elektronischen Komponenten 120. Durch eine Metallisierung dieser Vias 160 können die elektronischen Komponenten 120 später in geeigneter Weise über die beiden metallischen Schichten 134 und 136 und ggf. über weitere metallische Schichten (über weitere nicht dargestellte Vias) elektrisch kontaktiert werden).

Es wird darauf hingewiesen, dass Vias auch in anderen Lagen der Leiterplatte 100a eingebaut sein können. Beispielsweise können (weitere) Vias von der dielektrischen Schicht 110 bis zur metallischen Schicht 134 und/oder zwischen den beiden metallischen Schichten 132 und 134 eingebaut werden.

Die in Figur 1B dargestellte Leiterplatte 100b weist im Vergleich zu der Leiterplatte 100a zusätzlich einen strukturierten Kern 135 auf, welcher zwei strukturierte metallische Lagen und eine strukturierte dielektrische Schicht aufweist, welche sich zwischen den beiden metallische Lagen befindet. Wie aus Figur 1B ersichtlich, ist der Kern 135 so strukturiert und in Bezug zu der gesamten Leiterplatte 100b derart angeordnet, dass er abseits von den elektronischen Komponenten 120 in der (dicken) dielektrischen Schicht 114 eingebettet ist.

Ein weiterer Unterschied zwischen der Leiterplatte 100b und der Leiterplatte 100a besteht darin, dass nicht nur die elektronischen Komponenten 120 sondern auch die metallischen Schichten 130 und 132 mittels Vias 160 kontaktiert sind. Es wird darauf hingewiesen, dass die Vias 160, welche in den dielektrischen Schichten 110 und 112 ausgebildet sind, auch in der Leiterplatte 100a vorhanden sein können, jedoch in der Schnittdarstellung von Figur 1A nicht zu erkennen sind. In diesem Zusammenhang wird darauf hingewiesen, dass Vias im Prinzip in allen Lagen der Leiterplatte 100b eingebaut sein können.

Ein weiterer Unterschied zwischen der Leiterplatte 100b und der Leiterplatte 100a besteht darin, dass es sich bei der Leiterplatte 100b nicht um einen Schichtaufbau handelt, welcher für alle dielektrischen Schichten dasselbe vorstehend im Detail beschriebene dielektrische Material verwendet. Für die Leiterplatte 100b wurde vielmehr ein Mix aus diesem dielektrischen Material und (für den Kern) ein Material mit einem besonders kleinen CTE verwendet.

Die in Figur 1C dargestellte Leiterplatte 100c weist im Vergleich zu der Leiterplatte 100a zusätzlich als einen strukturierten Kern eine Sandwichstruktur auf, an welcher die beiden elektronischen Komponenten 120 angebracht sind. Diese Sandwichstruktur umfasst gemäß dem hier dargestellten Ausführungsbeispiel eine dielektrische Kern-Schicht 150, die sich zwischen der metallischen Schicht 136 und einer weiteren metallischen Schicht 138 befindet. Im Vergleich zu der Verwendung von lediglich der metallischen Schicht 136, wie es in den Figuren 1A und 1B dargestellt ist, stellt die Sandwichstruktur (Bezugszeichen 136, 150 und 138) eine deutlich stabilere Trägerstruktur für die beiden elektronischen Komponenten 120 dar.

Die dielektrische Kern-Schicht 150 weist ein dielektrisches Kern-Material auf, welches gemäß dem hier dargestellten Ausführungsbeispiel entlang der x-Achse und entlang der y-Achse einen thermischen Ausdehnungskoeffizienten im Bereich von 6 bis 9 ppm/K hat. In diesem Zusammenhang wird darauf hingewiesen, dass die x-Achse und die y-Achse eine xy-Ebene aufspannen, welche senkrecht zu der vertikalen z-Achse orientiert ist. Dies bedeutet, dass die flächigen Oberflächen der einzelnen Schichten der Leiterplatten 100a, 100b und 100b parallel zu dieser xy-Ebene orientiert sind.

Es wird darauf hingewiesen, dass zumindest eine der vorstehend beschriebenen dielektrischen Schichten auch eine dielektrische Prepreg-Schicht sein kann, welche die in diesem Dokument beschriebenen besonderen mechanischen und thermischen Eigenschaften hat und welche ein Materialverbund aus Glasfasern und Harz darstellt. Gleiches gilt auch für die nachfolgend beschriebenen Ausführungsbeispiele.

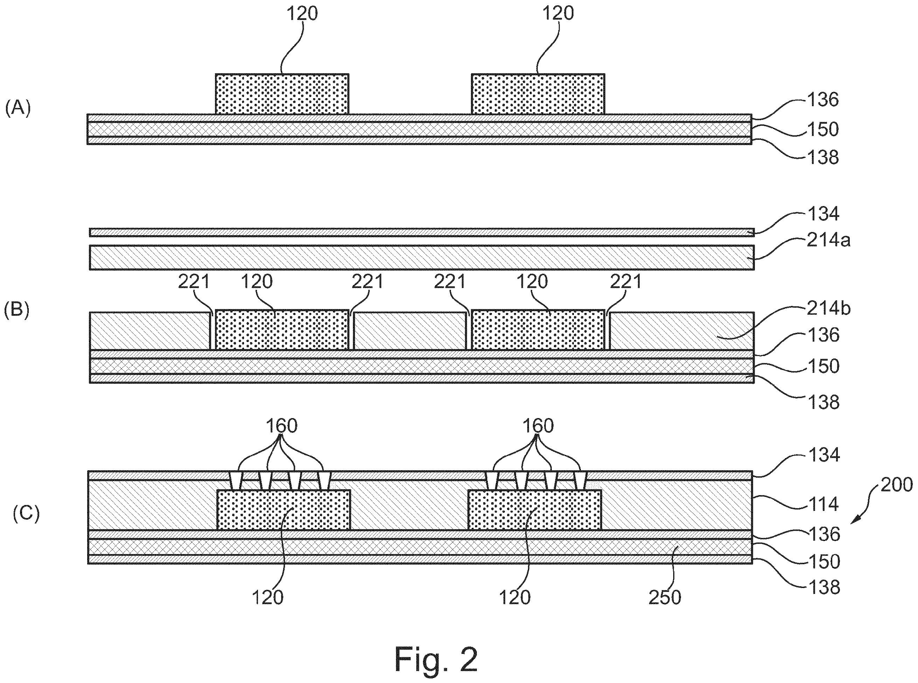

Die Figuren 2A bis 2C zeigen in einer Querschnittsdarstellung die Herstellung einer Leiterplatte 200, welche zwei eingebettete elektronische Komponenten 120 aufweist. Die beiden elektronischen Komponenten 120 sind, wie aus Figur 2A ersichtlich, zunächst auf der aus Figur 1C bekannten Sandwichstruktur aufgebracht, welche eine dielektrische Kern-Schicht 250 umfasst, die sich zwischen den beiden metallischen Schichten bzw. Metallfolien 136 und 138 befindet. Wie bereits vorstehend angemerkt, stellt im Vergleich zu der Verwendung von lediglich einer Metallfolie 136 die Sandwichstruktur (Bezugszeichen 136, 150, 138) eine deutlich stabilere Trägerstruktur für die beiden elektronischen Komponenten 120 dar. Dies erleichtert auf vorteilhafte Weise die Handhabung der Trägerstruktur für die beiden elektronischen Komponenten. Die Leiterplatte 200 entspricht dem unteren Teil der Leiterplatte 100c, die in Figur 1C dargestellt ist.

In Figur 2A ist dargestellt, dass gemäß dem hier dargestellten Ausführungsbeispiel die beiden elektronischen Komponenten 120 zunächst auf der Sandwichstruktur (Bezugszeichen 136, 150, 138) aufgebracht werden.

Wie aus Figur 2B ersichtlich, wird auf der Metallfolie 136 neben den elektronischen Komponenten 120 zunächst eine dielektrische Teilschicht 214b aufgebracht. Gemäß dem hier dargestellten Ausführungsbeispiel ist die obere Oberfläche der dielektrischen Teilschicht 214b im Wesentlichen bündig mit der Oberseite der elektronischen Komponente 120. Wie ferner aus der Figur 2B ersichtlich, reicht die Teilschicht 214b nicht ganz bis an die Seitenwand der elektronischen Komponente 120 heran, so dass sich in der 2D Schnittdarstellung von Figur 2B ein Spalt 121 ergibt, welcher in Wirklichkeit, d.h. in 3D, eine Beabstandung ist, welche die elektronische Komponente 120 umgibt.

Wie ferner aus Figur 2B ersichtlich, wird gemäß dem hier dargestellten Ausführungsbeispiel eine Deckelstruktur vorbereitet. Diese Deckelstruktur umfasst gemäß dem hier dargestellten Ausführungsbeispiel eine weitere dielektrische Teilschicht 214a, welche an der Unterseite der als Metallfolie ausgebildeten metallischen Schicht 134 ausgebildet ist.

Wie aus Figur 2C ersichtlich, wird die Deckelstruktur bestehend aus der Metallfolie 134 und der dielektrischen Teilschicht 214a von oben auf die Grundstruktur aufgesetzt, deren Oberseite durch die obere Fläche der beiden elektronischen Komponenten 120 sowie durch die obere Oberfläche der dielektrischen Teilschicht 214b gebildet ist. Danach wird der gesamte Schichtenaufbau in bekannter Weise verpresst. Dabei vereinigen sich die beiden dielektrischen Teilschichten 214a und 214b zu der einheitlichen dielektrischen Schicht 114. Infolge einer gewissen Fließfähigkeit des entsprechenden dielektrischen Materials werden bei dem Verpressen auch die Beabstandungen 221 aufgefüllt. Dadurch werden die elektronischen Komponenten 120 von allen Seiten von dem dielektrischen Material der dielektrischen Schicht 114 umgeben. Aufgrund der vorstehend beschriebenen mechanischen Eigenschaften des dielektrischen Materials sind die elektronischen Komponenten 120 auf besonders schonende und zugleich zuverlässige Weise in die dielektrische Schicht 114 eingebettet.

Nach dem Vorgang des Verpressens werden in bekannter Weise beispielsweise mittels Laserbohrens die Vias 160 ausgebildet. Gemäß dem hier dargestellten Ausführungsbeispiel erstrecken sich diese Vias 160 sowohl von oben als auch von unten bis hin zu den beiden elektronischen Komponenten 120. Durch eine Metallisierung dieser Vias 160 können die elektronischen Komponenten 120 später in geeigneter Weise elektrisch kontaktiert werden.

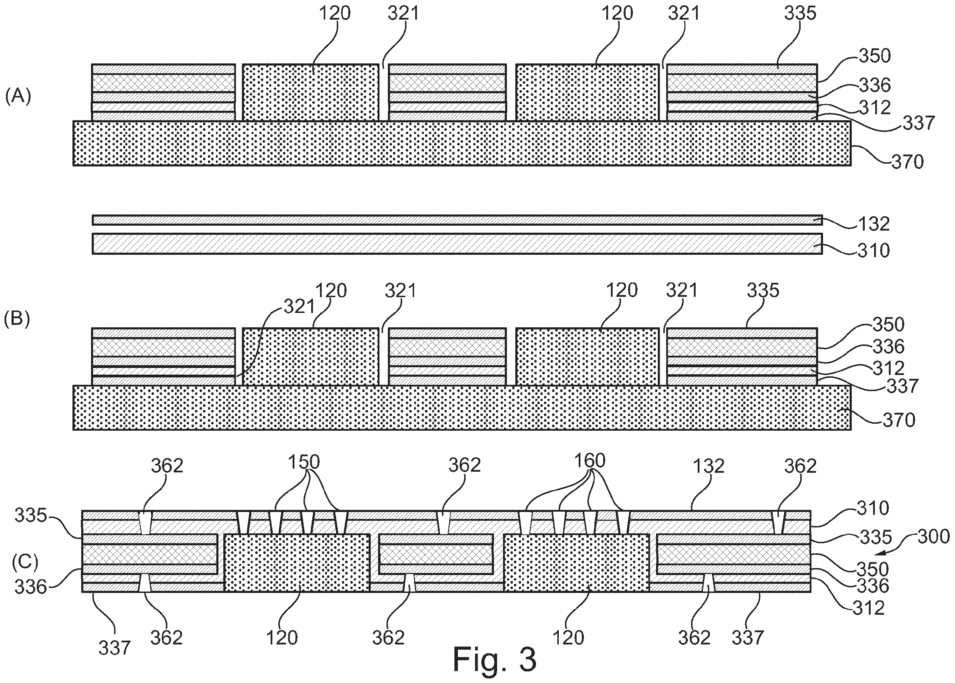

Die Figuren 3A, 3B und 3C zeigen in einer Querschnittsdarstellung die Herstellung einer Leiterplatte 300 unter Verwendung eines temporären Trägers 370. Die Leiterplatte 300 entspricht einem Teil der Leiterplatte 100c, die in Figur 1C dargestellt ist, bevor diejenigen Schichten aufgebracht werden, welche für die starke Asymmetrie der Leiterplatte 100c verantwortlich sind.

Wie aus Figur 3A ersichtlich, werden die beiden eingebetteten elektronischen Komponenten 120 zunächst auf einer Oberseite eines temporären Trägers 370 angebracht. Gemäß dem hier dargestellten Ausführungsbeispiel ist dieser temporäre Träger 370 eine adhäsive Folie, welche häufig auch als Tape bezeichnet wird.

Auf den temporären Träger 370 wird ferner (neben den elektronischen Komponenten 120) eine Schichtenfolge aufgebracht, welche gemäß dem hier dargestellten Ausführungsbeispiel aus folgenden Schichten besteht: (a) einer metallischen Schicht 337, (b) einer dielektrischen Schicht 312, (c) einer metallischen Schicht 338, (d) einer dielektrischen Kern-Schicht 350 sowie (e) einer metallischen Schicht 336.

Gemäß dem hier dargestellten Ausführungsbeispiel wird bei dem Ausbilden der o.g. Schichtenfolge jeweils zwischen einer Seitenwand der elektronischen Komponente 120 und derjenigen Seitenwand der Schichtenfolge, welche der elektronischen Komponente 120 zugewandt ist, ein Spalt bzw. eine Beabstandung 321 freigelassen. Diese Spalte bzw. Beabstandungen 321 können bereits bei einen sukzessiven Aufbringen der betreffenden Schichten der Schichtenfolge freigelassen werden. Alternativ können diese Spalte bzw. Beabstandungen 321 auch nach einen vollständigen Ausbilden einer Schichtenfolge, welche sich bis an die Seitenwand der elektronischen Komponente 120 erstreckt, durch eine geeignete Abtragung beispielsweise mittels eines Ätzvorgangs ausgebildet werden.

Wie aus Figur 3B ersichtlich, wird ferner eine Deckelstruktur bereitgestellt, welche gemäß dem hier dargestellten Ausführungsbeispiel eine Metallfolie 134 und eine an der Unterseite der Metallfolie 134 ausgebildete weitere dielektrische Schicht 310 umfasst.

Nach einem Aufsetzen der Trägerstruktur wird der resultierende Schichtenverbund verpresst. Dieses Verpressen kann insbesondere gemeinsam mit dem temporären Träger 370 erfolgen. Falls das Verpressen gemeinsam mit dem temporären Träger 370 erfolgt, dann wird dieser nach dem Vorgang des Verpressens von der Leiterplatte 300 entfernt (vgl. Figur 3C).

Auch in diesem Ausführungsbeispiel füllen sich bei dem Verpressen die Beabstandungen 321 mit dem dielektrischen Material, welches, wie vorstehend beschrieben, eine gewisse Kriechfähigkeit aufweist. Im Ergebnis ist daher die betreffende elektronische Komponente 120 zumindest weitgehend vollständig von dem dielektrischen Material mit seinen vorteilhaften Eigenschaften bezüglich Elastizität und thermischer Ausdehnung umgeben.

Wie ferner aus Figur 3C ersichtlich, werden in der Leiterplatte 300 nach dem Verpressen eine Vielzahl von Vias 160 ausgebildet. Über diese Vias 160 können in bekannter Weise nach einer geeigneten Metallisierung die metallischen Schichten 336 bzw. 338 sowie die elektronischen Komponenten 120 (von oben) elektrisch kontaktiert werden.

Es wird darauf hingewiesen, dass eine der Leiterplatte 300 entsprechende Leiterplatte auch ohne die dielektrische Kern-Schicht 350 und stattdessen mit einer weiteren dielektrischen Schicht realisiert werden kann. Ferner sind auch Schichtenfolgen möglich, bei denen die dielektrische Kernschicht an einer anderen Stelle ausgebildet ist.

Es wird ferner darauf hingewiesen, dass die Leiterplatte 300 auch als Halbzeug für die Herstellung einer größeren Leiterplattenstruktur verwendet werden kann.

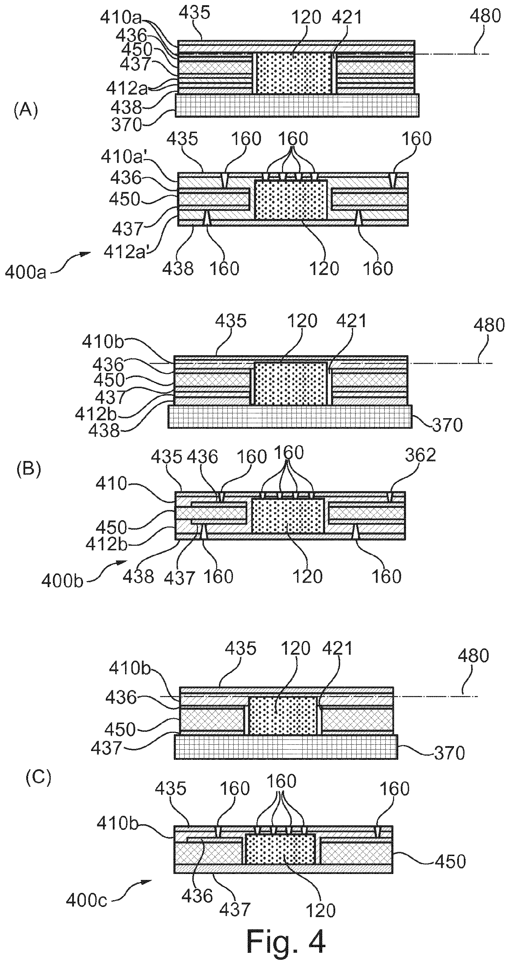

Die Figuren 4A, 4B und 4C zeigen verschiedene Leiterplatten 400a, 400b und 400c, welche verschiedene Dicken haben. Gemäß dem hier dargestellten Ausführungsformen hat die in Figur 4A dargestellte Leiterplatte 400a (ohne den temporären Träger 370) eine Dicke von ungefähr 220 µm. Dies entspricht der Dicke von bekannten Leiterplatten mit eingebetteten Komponenten. Die Leiterplatte 400b hat eine Dicke von ungefähr 185 µm und die Leiterplatte 410c hat eine Dicke von ungefähr 170 µm. Die dünnste Leiterplatte 400c ist damit um ca. 20% dünner als die Leiterplatte 400a, welche trotz der Verwendung des in diesem Dokument im Detail beschriebenen dielektrischen Materials nicht dünner ist als eine vergleichbare herkömmliche Leiterplatte. Es wird darauf hingewiesen, dass in der Realität die Dicken der Leiterplatten von der Höhe der eingebetteten Komponente abhängen. Die vorstehend genannten Dicken beziehen sich auf eine eingebettete Komponente mit einer Höhe von 150 µm.

In den oberen Darstellungen der Figuren 4A bis 4C ist der Schichtenverbund der jeweiligen Leiterplatte 400a, 400b bzw. 400c in einem unverpressten Zustand zusammen mit dem jeweiligen temporären Träger 370 dargestellt. In den unteren Darstellungen der Figuren 4A bis 4C ist die fertige verpresste Leiterplatte 400a, 400b bzw. 400c jeweils ohne den entsprechenden temporären Träger dargestellt.

Wie aus Figur 4A ersichtlich, ist oberhalb des temporären Trägers 370 eine Schichtstruktur aufgebaut, welche gemäß dem hier dargestellten Ausführungsbeispiel von unten nach oben die folgenden Schichten umfasst:
(a) eine metallische Schicht 438, (b) zwei dielektrische Teilschichten 412a, (c) eine metallische Schicht 437, (d) eine dielektrische Kern-Schicht 450, (e) eine metallische Schicht 436, (f) zwei dielektrische Teilschichten 410a und (g) eine metallische Schicht 435.

Gemäß dem hier dargestellten Ausführungsbeispiel ist innerhalb dieser Schichtenstruktur eine Kavität ausgebildet, in welcher sich eine elektronische Komponente 120 befindet. Diese Kavität wurde während des Aufbauens der Schichtenstruktur nach dem Ausbilden der unteren dielektrischen Teilschicht 410a ausgebildet. Erst nach einem Einsetzen der elektronischen Komponente 120 wurden die verbleibenden Schichten, das heißt die obere dielektrische Teilschicht 410a und die metallische Schicht 435 ausgebildet.

Wie aus Figur 4A ersichtlich, ist die Breite der Kavität etwas größer als die Breite der elektronischen Komponente 120. Wie aus der unteren Darstellung von Figur 4A ersichtlich, wird der entsprechende Hohlraum 421 jedoch bei einem Verpressen der Schichtenfolge infolge der vorstehend erläuterten Fließfähigkeit des dielektrischen Materials aufgefüllt. Dadurch ergibt sich eine Verbindung zwischen (a) der dielektrischen Prepreg Schicht 410a', welche durch ein druckinduziertes Verbinden der beiden dielektrischen Teilschichten 410a entsteht, und (b) der dielektrischen Schicht 412a', welche durch ein druckinduziertes Verbinden der beiden dielektrischen Teilschichten 412a entsteht. Damit ist die elektronische Komponente 120 an verschiedenen Seiten von dem erfindungsgemäßen dielektrischen Material umgeben, so dass sich eine besonders stressfreie Einbettung der elektronischen Komponente 120 in die Leiterplatte 400a ergibt.

Es wird darauf hingewiesen, dass die Höhe der in Figur 4A gezeigten Kavität größer sein kann als die Dicke der elektronischen Komponente 120. Dies hat den Vorteil, dass bei einem Verpressen kein bzw. nur sehr wenig Druck auf die elektronische Komponente 120 Bauteil ausgeübt wird.

Der Vollständigkeit halber wird noch erwähnt, dass auch in der Leiterplatte 400a geeignete Vias 160 ausgebildet werden können, welche nach einer in bekannter Weise durchgeführten Metallisierung elektrische Verbindungen erzeugen, die sich in vertikaler Richtung erstrecken. Wie aus der unteren Darstellung von Figur 4A ersichtlich, sorgen die Vias 160 für elektrische Verbindungen (a) zwischen der elektronischen Komponente 120 und der Metallschicht 435 und (b) zwischen den beiden inneren metallischen Schichten 436 und 437 mit der jeweils benachbarten äußeren metallischen Schicht 435 bzw. 438.

In Figur 4B ist die Herstellung einer Leiterplatte 400b dargestellt, welche sich von der Herstellung der Leiterplatte 400a darin unterscheidet, dass anstelle der dielektrischen Teilschichten 410a und 412a von Anfang an eine einheitliche dielektrische Schicht 410b bzw. 412b verwendet wird. Die Leiterplatte 400b unterscheidet sich von der Leiterplatte 400a ferner dadurch, dass die elektronische Komponente 120 bereits vor dem Vorgang des Verpressens des Schichtenverbundes in die obere dielektrische Schicht 410b hinein gedrückt wurde. Der Unterschied in der Höhe zwischen dem Hohlraum 421 und der elektronischen Komponente 120 liegt im Bereich zwischen ca. 5 µm und 15 µm. Ein solches Eindrücken der elektronische Komponente 120 ist ohne eine Beschädigung derselben nur deshalb möglich, weil das Material der oberen dielektrischen Schicht 410b die in diesem Dokument beschriebenen herausragenden Eigenschaften in Bezug auf das Elastizitätsmodul E und den thermischen Ausdehnungskoeffizienten hat. Bei der Verwendung eines herkömmlichen dielektrischen (Prepreg-)Materials würde ein solches Hineindrücken zu einer Zerstörung der elektronischen Komponente 120 führen. In diesem Zusammenhang ist es prozesstechnisch auch von Bedeutung, dass das verwendete dielektrische Material auch noch bei Temperaturen von unter 100°C und insbesondere sogar noch bei Raumtemperatur die in diesem Dokument beschriebene Verformbarkeit aufweist. Auch in Figur 4B ist das Eindringen des dielektrischen Materials in den Hohlraum 421 innerhalb der Kavität, in welcher sich die elektronische Komponente 120 befindet, zu erkennen.

In Figur 4C ist die Herstellung einer Leiterplatte 400c dargestellt, welche sich von der Herstellung der Leiterplatte 400b darin unterscheidet, dass die untere dielektrische Schicht 412b sowie die untere metallische Schicht 438 nicht verwendet werden. Es wird darauf hingewiesen, dass das Weglassen der metallischen Schicht 438 und insbesondere das Weglassen der dielektrischen Schicht 412b lediglich deshalb möglich ist, weil das dielektrische Material der verbleibenden dielektrischen Schicht 410b die in diesem Dokument beschriebenen herausragenden Eigenschaften hinsichtlich seiner Elastizität, Fließfähigkeit sowie hinsichtlich seiner thermischen Ausdehnung aufweist. Ferner ist bei der Leiterplatte 400c die Kavität für die elektronische Komponente 120 in einem strukturierten Kern bestehend aus den Schichten 437, 450 und 436 ausgebildet. Wie aus der oberen Abbildung von Figur 4C ersichtlich, ist die elektronische Komponente 120 höher als der Kern bzw. als die Kavität. Beim Verpressen stellt die dielektrische Schicht 410b das Material zur Verfügung, welches in den Hohlraum 421 eindringt und die elektronische Komponente 120 auf mechanisch schonende Weise umgibt.

Die Reduktion der Aufbaustärke ist in den Figuren 4A bis 4C jeweils durch eine "Strich-Punkt-Linie" 480 veranschaulicht, welche die Oberseite der elektronischen Komponente 120 angibt. Anhand dieser "Strich-Punkt-Linie" 480 kann die Höhe des Schichtenaufbaus oberhalb der elektronischen Komponente 120 deutlich erkannt werden. In diesem Zusammenhang wird noch einmal darauf hingewiesen, dass das in den Figuren 4A bis 4C illustrierte Reduzieren der Dicke einer mit einer eingebetteten elektronischen Komponente 120 hergestellten Leiterplatte 400c in der Praxis nur mit dem in diesem Dokument beschriebenen dielektrischen Material möglich ist, weil andere dielektrischen Materialen zu Leiterplatten führen würden, welche die heutzutage sehr hohen Qualitätsanforderungen insbesondere hinsichtlich ihrer mechanischen und thermischen Stabilität in keiner Weise erfüllen könnten.

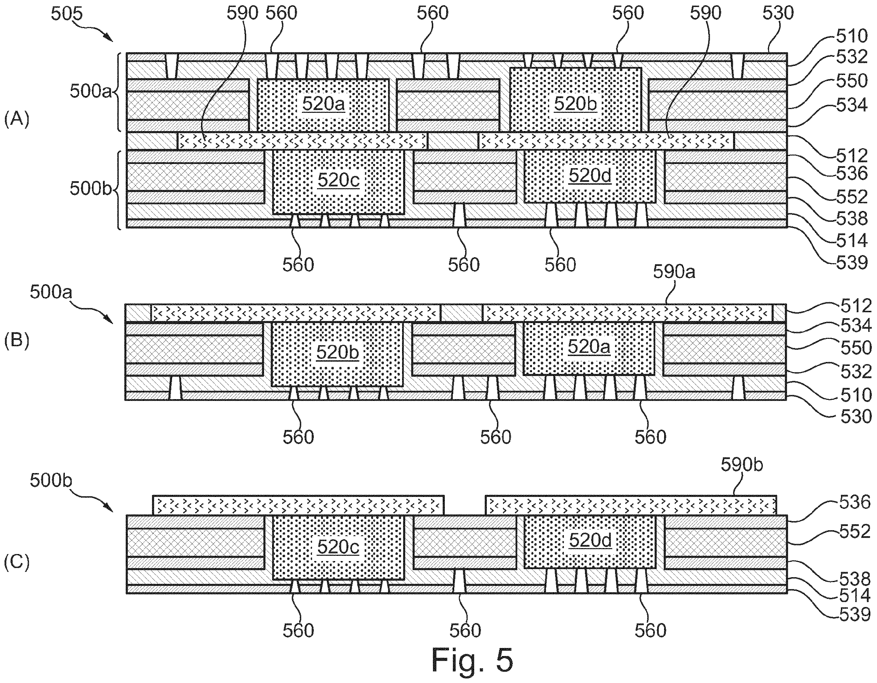

Figuren 5A, 5B und 5C illustrieren das Auftrennen einer symmetrischen Leiterplattenstruktur 505 in zwei asymmetrische Leiterplatten 500a und 500b. Wie aus Figur 5A ersichtlich, weist gemäß dem hier dargestellten Ausführungsbeispiel die im wesentlichen symmetrische Leiterplattenstruktur 505 von oben nach unten folgenden Schichtaufbau auf:
- eine metallische Schicht 530
- eine dielektrische Schicht 510
- eine metallische Schicht 532
- eine dielektrische Kern-Schicht 550
- eine metallische Schicht 534
- eine dielektrische Schicht 512 sowie eine Ablöseschicht 590, welche jeweils in verschiedenen flächigen Teilbereichen innerhalb einer zur vertikalen z-Achse senkrechten xy-Ebene in dem dargestellten Schichtenverbund eine gemeinsame Schicht bilden
- eine metallische Schicht 536
- eine dielektrische Kern-Schicht 552
- eine metallische Schicht 538
- eine dielektrische Schicht 514
- eine metallische Schicht 539

An diese Stelle wird darauf hingewiesen, dass für das hier beschriebene symmetrische Herstellungsverfahren alle vorstehend anhand der Figuren 1 bis 4 beschriebenen asymmetrischen Aufbauten verwendet werden können.

Wie aus Figur 5A ersichtlich, sind oberhalb der Ablöseschicht 590 zwei elektronische Komponenten 520a sowie 520b eingebettet. Dabei ist die jeweilige elektronische Komponente 520a, 520b von oben und von der Seite vollständig in die dielektrische Schicht 510 mit ihren vorteilhaften mechanischen und thermischen Eigenschaften eingebettet. An der Unterseite der beiden elektronischen Komponenten 520a sowie 520b liegt die Ablöseschicht 590 an.

In entsprechender Weise sind unterhalb der Ablöseschicht 590 zwei elektronische Komponenten 520c sowie 520d eingebettet. Diese sind an ihrer Unterseite sowie an ihren seitlichen Flächen vollständig von der dielektrischen Schicht 514 umgeben. An der Oberseite der beiden elektronischen Komponenten 520c sowie 520d liegt die Ablöseschicht 590 an.

Ferner sind, wie ebenfalls aus Figur 5A ersichtlich, eine Vielzahl von Vias 560 für jeweils eine geeignete elektrische Kontaktierung ausgebildet.

Die Figuren 5B und 5C zeigen die zwei asymmetrischen Leiterplatten 500a und 500b, welche durch ein Auftrennen des Schichtenverbundes 505 an der Ablöseschicht sowie an den flächig vergleichsweise kleinen Teilbereichen der dielektrischen Schicht 512 entstehen. Die Teile der Ablöseschicht, welche nach dem Auftrennen entstehen, sind in den Figuren 5B und 5C mit den Bezugszeichen 590a bzw. 590b gekennzeichnet.

Der Vorteil der hier beschriebenen Herstellung von zwei asymmetrischen Leiterplatten 500a und 500b besteht darin, dass etliche in Figur 5 nicht dargestellte Prozessierungsschritte an dem im wesentlichen symmetrischen Schichtenaufbau 505 durchgeführt werden können.

Abschließend wird darauf hingewiesen, dass in allen vorstehend beschriebenen Ausführungsbeispielen die jeweilige Leiterplatte auch ohne eine eingebettete Komponente 120 aufgebaut werden kann. Dies bedeutet, dass die entsprechende Leiterplatte als Bauelementeträger verwendet wird, an welchem lediglich an der flächigen Oberseite und/oder an der flächigen Unterseite elektronische Bauelemente angebracht bzw. bestückt werden können.

### BEZUGSZEICHEN:

- 100a,b,c: Leiterplatte mit eingebetteten elektronischen Komponenten
- 110: dielektrische Schicht
- 112: dielektrische Schicht
- 114: dielektrische Schicht
- 120: elektronische Komponente
- 130: metallische Schicht / Metallfolie
- 132: metallische Schicht / Metallfolie
- 134: metallische Schicht / Metallfolie
- 135: strukturierter Kern
- 136: metallische Schicht / Metallfolie
- 136: metallische Schicht / Metallfolie
- 138: metallische Schicht / Metallfolie
- 150: dielektrische Kern-Schicht
- 160: Vias

- 200: Leiterplatte mit eingebetteten elektronischen Komponenten
- 214a/b: dielektrische Teilschicht
- 221: Spalt / Beabstandung

- 300: Leiterplatte mit eingebetteten elektronischen Komponenten
- 310: dielektrische Schicht
- 312: dielektrische Schicht
- 321: Spalt / Beabstandung
- 336: metallische Schicht
- 337: metallische Schicht
- 338: metallische Schicht
- 350: dielektrische Kern-Schicht
- 370: temporärer Träger / Tape
- 400a,b,c: Leiterplatte mit eingebetteter elektronischer Komponente
- 410a: dielektrische Teilschichten
- 410a': vereinigte dielektrische Schicht
- 410b: dielektrische Schicht
- 412a: dielektrische Teilschichten
- 412a': vereinigte dielektrische Schicht
- 412b: dielektrische Schicht
- 421: Hohlraum
- 435: metallische Schicht
- 436: metallische Schicht
- 437: metallische Schicht
- 438: metallische Schicht
- 450: dielektrische Kern-Schicht
- 480: Strich-Punkt-Linie

- 500a: Leiterplatte (asymmetrisch)
- 500b: Leiterplatte (asymmetrisch)
- 505: Leiterplattenstruktur (symmetrischer Schichtaufbau)
- 510: dielektrische Schicht
- 512: dielektrische Schicht
- 514: dielektrische Schicht
- 530: metallische Schicht
- 532: metallische Schicht
- 534: metallische Schicht
- 536: metallische Schicht
- 538: metallische Schicht
- 539: metallische Schicht
- 550: dielektrische Kern-Schicht
- 552: dielektrische Kern-Schicht
- 560: Vias
- 590: Ablöseschicht
- 590a/b: Teil von Ablöseschicht

## Patentansprüche

1. Leiterplatte aufweisend
einen Schichtenverbund mit
zumindest einer dielektrischen Schicht (114), welche parallel zu einer xy-Ebene, die durch eine x-Achse und eine dazu senkrechte y-Achse aufgespannt ist, eine flächige Ausdehnung aufweist und
entlang einer z-Achse, welche senkrecht zu der x-Achse und zu der y-Achse ist, eine Schichtdicke aufweist; und
zumindest einer metallischen Schicht (136), welche flächig an der dielektrischen Schicht (114) angebracht ist; wobei
der Schichtenverbund entlang der z-Achse frei von einer Symmetrieebene ist, welche parallel zu der xy-Ebene orientiert ist, und
die dielektrische Schicht (114) ein dielektrisches Material aufweist, welches
- ein Elastizitätsmodul E im Bereich zwischen 1 und 20 GPa und
- entlang der x-Achse und entlang der y-Achse einen thermischen Ausdehnungskoeffizienten im Bereich zwischen 0 und 17 ppm/K hat;
wobei das dielektrische Material eine Kriecheigenschaft aufweist, welche durch zumindest eine der folgenden Eigenschaften bestimmt ist:
(a) eine plastische Verformbarkeit im Bereich zwischen 0,01% und 10%, insbesondere im Bereich zwischen 0,1% und 5% und weiter insbesondere im Bereich zwischen 0,2% und 2%,
(b) eine viscoelastische Verformbarkeit im Bereich zwischen 0% und 10%, insbesondere im Bereich zwischen 0% und 5% und weiter insbesondere im Bereich zwischen 0% und 3%.

2. Leiterplatte gemäß dem vorangehenden Anspruch, aufweisend zumindest eines der folgenden Merkmale:
wobei das dielektrische Material eine Mischung oder ein Copolymer ist bestehend aus zumindest einem ersten Material mit einem ersten Elastizitätsmodul E und einem ersten thermischen Ausdehnungskoeffizienten und einem zweiten Material mit einem zweiten Elastizitätsmodul E und einem zweiten thermischen Ausdehnungskoeffizienten. Der erste Elastizitätsmodul ist größer als der zweite Elastizitätsmodul und der erste thermische Ausdehnungskoeffizient ist kleiner als der zweite thermische Ausdehnungskoeffizient;
wobei das erste Material eine erste Glasübergangstemperatur aufweist und das zweite Material eine zweite Glasübergangstemperatur aufweist;
wobei das erste Material ein Harz und einen sich darin befindlichen harten Füllstoff aufweist.

3. Leiterplatte gemäß dem vorangehenden Anspruch, wobei das zweite Material ein thermisch aushärtbares Harz aufweist, welches mit einem weichmachenden Stoff verbunden ist.

4. Leiterplatte gemäß einem der vorangehenden Ansprüche, aufweisend zumindest eines der folgenden Merkmale:
wobei der Wert für das Elastizitätsmodul E im Bereich zwischen 2 und 7 GPa und insbesondere im Bereich zwischen 3 und 5 GPa liegt;
wobei der thermische Ausdehnungskoeffizient im Bereich zwischen 3 und 10 ppm/K und insbesondere im Bereich zwischen 5 und 8 ppm/K liegt;
wobei der Schichtenverbund entlang der z-Achse eine Asymmetrie bezüglich der Anzahl der Schichten aufweist;
wobei der Schichtenverbund entlang der z-Achse eine Asymmetrie bezüglich der Dicken einzelnen Schichten aufweist;
wobei der Schichtenverbund entlang der z-Achse eine Asymmetrie bezüglich der Materialien einzelnen Schichten aufweist.

5. Leiterplatte gemäß einem der vorangehenden Ansprüche, ferner aufweisend zumindest eines der folgenden Merkmale:
eine Komponente, insbesondere eine elektronische Komponente (120), welche in der dielektrischen Schicht (114) und/oder in einer dielektrischen Kern-Schicht der Leiterplatte (200) eingebettet ist;
wobei die Komponente (120) in der dielektrischen Schicht (114) eingebettet ist;
wobei die dielektrische Kern-Schicht (150), welche flächig an der metallischen Schicht (136) und/oder an der dielektrischen Schicht (114) angebracht ist;
wobei die Komponente (120) in der dielektrischen Kern-Schicht eingebettet ist und die dielektrische Schicht oberhalb oder unterhalb der dielektrischen Kern-Schicht sowie der eingebetteten elektronischen Komponente angeordnet ist;
wobei die Komponente in der dielektrischen Kern-Schicht eingeklebt ist;
wobei die dielektrische Kern-Schicht (150) ein dielektrisches Kern-Material aufweist, welches entlang der x-Achse und entlang der y-Achse einen thermischen Ausdehnungskoeffizienten von 0 bis 11 ppm/K, insbesondere von 2 bis 10 ppm/K und weiter bevorzugt von 3 bis 9 ppm/K hat;
wobei die Gesamtdicke des Schichtenverbundes kleiner ist als ungefähr 200 µm, insbesondere kleiner als ungefähr 190 µm und weiter insbesondere kleiner als ungefähr 180 µm;
wobei die dielektrische Schicht eine dielektrische Prepreg-Schicht ist und/oder
das dielektrische Material ein dielektrisches Prepreg-Material ist.

6. Verfahren zum Herstellen einer Leiterplatte (200), insbesondere einer Leiterplatte (200) gemäß einem der vorangehenden Ansprüche, das Verfahren aufweisend
Aufbauen eines übergeordneten Schichtenverbundes mit
zumindest einer dielektrischen Schicht (114), welche parallel zu einer xy-Ebene, die durch eine x-Achse und eine dazu senkrechte y-Achse aufgespannt ist, eine flächige Ausdehnung aufweist und
entlang einer z-Achse, welche senkrecht zu der x-Achse und zu der y-Achse ist, eine Schichtdicke aufweist; und
zumindest einer metallischen Schicht (136), welche flächig an der dielektrischen Schicht (114) angebracht ist; wobei
der Schichtenverbund entlang der z-Achse frei von einer Symmetrieebene ist, welche parallel zu der xy-Ebene orientiert ist, und
die dielektrische Schicht (114) ein dielektrisches Material aufweist, welches
- ein Elastizitätsmodul E im Bereich zwischen 1 und 20 GPa und
- entlang der x-Achse und entlang der y-Achse einen thermischen Ausdehnungskoeffizienten im Bereich zwischen 0 und 17 ppm/K hat,
wobei das dielektrische Material eine Kriecheigenschaft aufweist, welche durch zumindest eine der folgenden Eigenschaften bestimmt ist:
(a) eine plastische Verformbarkeit im Bereich zwischen 0,01% und 10%, insbesondere im Bereich zwischen 0,1% und 5% und weiter insbesondere im Bereich zwischen 0,2% und 2%,
(b) eine viscoelastische Verformbarkeit im Bereich zwischen 0% und 10%, insbesondere im Bereich zwischen 0% und 5% und weiter insbesondere im Bereich zwischen 0% und 3%.

7. Verfahren gemäß dem vorangehenden Anspruch, ferner aufweisend
Ausbilden einer Ausnehmung in der dielektrischen Schicht (114) und/oder in einer dielektrischen Kern-Schicht; und
Einbringen einer elektronischen Komponente (120) in die Ausnehmung.

8. Verfahren gemäß dem vorangehenden Anspruch, wobei
die Ausnehmung größer ist als die elektronische Komponente (120), so dass nach einem Einbringen der der elektronischen Komponente (120) in die Ausnehmung ein Hohlraum (221) verbleibt.

9. Verfahren gemäß einem der beiden vorangehenden Ansprüche, ferner aufweisend
falls die elektronische Komponente (120) in der dielektrischen Schicht (214b) eingebracht ist,
Aufbringen einer weiteren dielektrischen Schicht (214a) auf die dielektrische Schicht (214b) und die elektronischen Komponente (120), wobei die weitere dielektrische Schicht (214a) die gleichen Eigenschaften hat wie die dielektrische Schicht (214b); und
falls die elektronische Komponente in der dielektrischen Kern-Schicht eingebettet ist,
Aufbringen der dielektrischen Schicht auf die dielektrische Kern-Schicht und die elektronische Komponente.

10. Verfahren gemäß einem der vorangehenden Ansprüche 6 bis 9, ferner aufweisend
Ausbilden einer metallischen Schicht (134) an der dielektrischen Schicht.

11. Verfahren gemäß einem der vorangehenden Ansprüche 6 bis 10, ferner aufweisend
Verpressen sämtlicher Schichten der Leiterplatte (200).

12. Verfahren zum Herstellen einer Leiterplattenstruktur, das Verfahren aufweisend
Herstellen einer ersten Leiterplatte (200) mit einem Verfahren gemäß einem der vorangehenden Ansprüche 6 bis 11;
Herstellen einer zweiten Leiterplatte (200) mit einem Verfahren gemäß einem der vorangehenden Ansprüche 6 bis 11; und
Zusammenfügen der ersten Leiterplatte (200) und der zweiten Leiterplatte (200), so dass die resultierende Leiterplattenstruktur zumindest eine Dicke aufweist, welche sich aus der Summe von einer ersten Dicke der ersten Leiterplatte und einer zweiten Dicke der zweiten Leiterplatte ergibt.

13. Verfahren gemäß dem vorangehenden Anspruch, wobei
die resultierende Leiterplattenstruktur eine symmetrische Gesamtschichtenfolge aufweist.

14. Verfahren zum Herstellen von zwei prozessierten Leiterplatten, das Verfahren aufweisend
Aufbauen eines Schichtenverbundes (505) aufweisend
eine erste Leiterplatte (500a) gemäß einem der Ansprüche 1 bis 5,
eine zweite Leiterplatte (500b) gemäß einem der Ansprüche 1 bis 5 und
eine Ablöseschicht (590), welche zwischen der ersten Leiterplatte und der zweiten Leiterplatte angeordnet ist;
Prozessieren des gesamten Schichtenverbundes (505); und
Auftrennen der Schichtenverbundes (505) an der Ablöseschicht (590), so dass eine erste prozessierte Leiterplatte (500a) und eine zweite prozessierte Leiterplatte (500b) mit jeweils einem asymmetrischen Schichtaufbau entstehen.

15. Verfahren gemäß dem vorangehenden Anspruch, aufweisend zumindest eines der folgenden Merkmale:
wobei der aufgebaute Schichtenverbund (505) entlang der z-Achse eine Symmetrieebene aufweist, welche parallel zu der xy-Ebene orientiert ist;
wobei die Ablöseschicht (590) ein druckfähiges Haftreduzierungsmaterial aufweist und wobei das Verfahren ferner aufweist
Drucken des Haftreduzierungsmaterials auf zumindest einen Teilbereich der ersten Leiterplatte (500a) oder auf zumindest einen Teilbereich der zweiten Leiterplatte (500a).

## Claims

1. Circuit board
a layered composite with
at least one dielectric layer (114) comprising, parallel to an xy plane which is spanned by an x-axis and a y-axis perpendicular thereto, a planar extent, and
comprising a layer thickness along a z-axis which is perpendicular to the x-axis and to the y-axis; and
at least one metallic layer (136) which is surface-mounted on the dielectric layer (114); wherein
the layered composite along the z-axis is free of a symmetry plane oriented parallel to the xy plane, and
the dielectric layer (114) comprises a dielectric material comprising
- a modulus of elasticity E in the range between 1 and 20 GPa and
- a coefficient of thermal expansion in the range between 0 and 17 ppm/K along the x-axis and along the y-axis;
said dielectric material has a creep property determined by at least one of the following properties:
(a) a plastic deformability in the range between 0.01% and 10%, particularly in the range between 0.1% and 5% and further particularly in the range between 0.2% and 2%,
(b) viscoelastic deformability in the range between 0% and 10%, particularly in the range between 0% and 5% and further particularly in the range between 0% and 3%.

2. Circuit board according to the preceding claim, comprising at least one of the following features:
said dielectric material is a mixture or a copolymer consisting of at least a first material having a first modulus of elasticity E and a first coefficient of thermal expansion and a second material having a second modulus of elasticity E and a second coefficient of thermal expansion. The first modulus of elasticity is greater than the second modulus of elasticity and the first coefficient of thermal expansion is less than the second coefficient of thermal expansion;
said first material has a first glass transition temperature and the second material has a second glass transition temperature;
said first material comprising a resin and a hard filler therein.

3. Circuit board according to the preceding claim, wherein
the second material comprises a thermally curable resin bonded to a softening agent.

4. Circuit board according to one of the preceding claims comprising at least one of the following features:
said value of the modulus of elasticity E being in the range between 2 and 7 GPa and particularly in the range between 3 and 5 GPa;
said coefficient of thermal expansion being in the range between 3 and 10 ppm/K and particularly in the range between 5 and 8 ppm/K;
said layered composite has an asymmetry along the z-axis with respect to the number of layers;
said layered composite has an asymmetry along the z-axis with respect to the thickness of individual layers;
said layered composite has an asymmetry along the z-axis with respect to the materials of individual layers.

5. Circuit board according to one of the preceding claims, further comprising at least one of the following features:
a component, particularly an electronic component (120), embedded in the dielectric layer (114) and/or in a dielectric core layer of the circuit board (200);
said component (120) being embedded in said dielectric layer (114);
said dielectric core layer (150) is surface-mounted to the metallic layer (136) and/or to the dielectric layer (114);
said component (120) being embedded in said dielectric core layer and said dielectric layer being disposed above or below said dielectric core layer and said embedded electronic component;
said component being adhered in the dielectric core layer;
said dielectric core layer (150) comprises a dielectric core material having along the x-axis and along the y-axis a coefficient of thermal expansion from 0 to 11 ppm/K, particularly from 2 to 10 ppm/K and more preferably from 3 to 9 ppm/K;
said total thickness of the layered composite is less than about 200 µm, particularly less than about 190 µm and further particularly less than about 180 µm;
said dielectric layer is a dielectric prepreg layer and/or
said dielectric material is a dielectric prepreg material.

6. Method of manufacturing a circuit board (200), particularly a circuit board (200), according to one of the preceding claims, the method comprising
building a higher-level layered composite with
at least one dielectric layer (114) comprising parallel to an xy plane which is spanned by an x-axis and a y-axis perpendicular thereto, a planar extent, and
comprising a layer thickness along a z-axis which is perpendicular to the x-axis and to the y-axis; and
at least one metallic layer (136) which is surface-mounted on the dielectric layer (114); wherein
the layered composite along the z-axis is free of a symmetry plane oriented parallel to the xy plane, and
the dielectric layer (114) comprises a dielectric material comprising
- a modulus of elasticity E in the range between 1 and 20 GPa and
- coefficient of thermal expansion in the range between 0 and 17 ppm/K along the x-axis and along the y-axis,
said dielectric material has a creep property determined by at least one of the following properties:
(a) a plastic deformability in the range between 0.01% and 10%, particularly in the range between 0.1% and 5% and further particularly in the range between 0.2% and 2%,
(b) viscoelastic deformability in the range between 0% and 10%, particularly in the range between 0% and 5% and further particularly in the range between 0% and 3%.

7. Method according to the preceding claim, further comprising
forming a recess in the dielectric layer (114) and/or in a dielectric core layer; and
inserting of an electronic component (120) into the recess.

8. Method in accordance with the preceding claim, wherein
the recess is larger than the electronic component (120) so that a cavity (221) remains after inserting the electronic component (120) into the recess.

9. Method according to either of the preceding two claims, further comprising if the electronic component (120) is inserted in the dielectric layer (214b),
applying a further dielectric layer (214a) on said dielectric layer (214b) and said electronic component (120) with the same properties as said dielectric layer (214b); and
if the electronic component is embedded in the dielectric core layer,
applying the dielectric layer on the dielectric core layer and the electronic component.

10. Method according to any of above claims 6 to 9, further comprising forming a metallic layer (134) on the dielectric layer.

11. Method according to any of above claims 6 to 10, further comprising laminating of all layers of the circuit board (200).

12. Method of manufacturing a circuit board structure, the method comprising
manufacturing a first circuit board (200) by a method according to any of above claims 6 to 11;
manufacturing a second circuit board (200) by a method according to any of above claims 6 to 11; and
assembling the first circuit board (200) and the second circuit board (200) so that the resulting circuit board structure has at least one thickness resulting from the sum of a first thickness of the first circuit board and a second thickness of the second circuit board.

13. Method according to the preceding claim, wherein
the resulting circuit board structure has a symmetrical overall layer sequence.

14. Method of manufacturing two processed circuit boards, the method comprising
building a layered composite (505) comprising
a first circuit board (500a) according to any of claims 1 to 5,
a second circuit board (500b) according to any of claims 1 to 5; and
a release layer (590) disposed between said first circuit board and said second circuit board;
processing the entire layered composite (505); and
separating the layered composite (505) at the release layer (590) to form a first processed circuit board (500a) and a second processed circuit board (500b) each having an asymmetric layer structure.

15. A method according to the preceding claim comprising at least one of the following features:
said built-up layered composite (505) has along the z-axis a plane of symmetry oriented parallel to the xy plane;
said release layer (590) comprising a printable adhesion reducing material, and the method further comprising
printing said adhesion reducing material on at least a portion of said first circuit board (500a) or on at least a portion of said second circuit board (500a).

## Revendications

1. Carte de circuits imprimés présentant
un composite stratifié avec
au moins une couche diélectrique (114) qui présente, parallèlement à un plan xy qui est défini par un axe x et un axe y perpendiculaire à celui-ci, une extension plane et
présente, le long d'un axe z qui est perpendiculaire à l'axe x et à l'axe y, une épaisseur de couche ; et
au moins une couche métallique (136) qui est montée à plat au niveau de la couche diélectrique (114) ; **caractérisée en ce que**
le composite stratifié est, le long de l'axe z, exempt d'un plan de symétrie qui est orienté parallèlement au plan xy, et
la couche diélectrique (114) présente un matériau diélectrique qui a
- un module d'élasticité E dans la plage entre 1 et 20 GPa et
- le long de l'axe x et le long de l'axe y, un coefficient d'extension thermique dans la plage entre 0 et 17 ppm/K;
le matériau diélectrique présentant un comportement au fluage qui est déterminé par au moins une des propriétés suivantes :
(a) une déformabilité plastique dans la plage entre 0,01 % et 10 %, en particulier dans la plage entre 0,1 % et 5 % et plus particulièrement dans la plage entre 0,2 % et 2 %,
(b) une déformabilité viscoélastique dans la plage entre 0 % et 10 %, en particulier dans la plage entre 0 % et 5 % et plus particulièrement dans la plage entre 0 % et 3 %.

2. Carte de circuits imprimés selon la revendication précédente, présentant au moins une des caractéristiques suivantes :
**caractérisée en ce que** le matériau diélectrique est un mélange ou un copolymère se composant d'au moins un premier matériau avec un premier module d'élasticité E et un premier coefficient d'extension thermique et un second matériau avec un second module d'élasticité E et un second coefficient d'extension thermique. Le premier module d'élasticité est supérieur au second module d'élasticité et le premier coefficient d'extension thermique est inférieur au second coefficient d'extension thermique ;
le premier matériau présentant une première température de transition vitreuse et le second matériau présentant une seconde température de transition vitreuse ;
le premier matériau présentant une résine et une substance de remplissage dure se trouvant dans celle-ci.

3. Carte de circuits imprimés selon l'une quelconque des revendications précédentes, **caractérisée en ce que**
le second matériau présente une résine thermodurcissable qui est reliée à une substance émolliente.

4. Carte de circuits imprimés selon l'une quelconque des revendications précédentes, présentant au moins une des caractéristiques suivantes :
**caractérisée en ce que** la valeur pour le module d'élasticité E se trouve dans la plage entre 2 et 7 GPa et en particulier dans la plage entre 3 et 5 GPa ;
le coefficient d'extension thermique se trouvant dans la plage entre 3 et 10 ppm/K et en particulier dans la plage entre 5 et 8 ppm/K ;
le composite stratifié présentant, le long de l'axe z, une asymétrie par rapport au nombre des couches ;
le composite stratifié présentant, le long de l'axe z, une asymétrie par rapport aux épaisseurs de couches individuelles ;
le composite stratifié présentant, le long de l'axe z, une asymétrie par rapport aux matériaux de couches individuelles.

5. Carte de circuits imprimés selon l'une quelconque des revendications précédentes, présentant en outre au moins une des caractéristiques suivantes :
un composant, en particulier un composant électronique (120), qui est intégré dans la couche diélectrique (114) et/ou dans une couche centrale diélectrique de la carte de circuits imprimés (200) ;
**caractérisée en ce que** le composant (120) est intégré dans la couche diélectrique (114) ;
la couche centrale diélectrique (150) qui est montée à plat au niveau de la couche métallique (136) et/ou au niveau de la couche diélectrique (114) ;
le composant (120) étant intégré dans la couche centrale diélectrique et la couche diélectrique étant agencée au-dessus ou en dessous de la couche centrale diélectrique ainsi que du composant électronique intégré ;
le composant étant collé dans la couche centrale diélectrique ;
la couche centrale diélectrique (150) présentant un matériau central diélectrique qui a, le long de l'axe x et le long de l'axe y, un coefficient d'extension thermique de 0 à 11 ppm/K, en particulier de 2 à 10 ppm/K et de manière davantage préférée de 3 à 9 ppm/K ;
l'épaisseur entière du composite stratifié étant inférieure à environ 200 µm, en particulier inférieure à environ 190 µm et plus particulièrement inférieure à environ 180 µm ;
la couche diélectrique étant une couche de préimprégné diélectrique et/ou
le matériau diélectrique étant un matériau de préimprégné diélectrique.

6. Procédé de fabrication d'une carte de circuits imprimés (200), en particulier d'une carte de circuits imprimés (200) selon l'une quelconque des revendications précédentes, le procédé présentant
l'établissement d'un composite stratifié supérieur avec
au moins une couche diélectrique (114) qui présente, parallèlement à un plan xy qui est défini par un axe x et un axe y perpendiculaire à celui-ci, une extension plate et
présente, le long d'un axe z qui est perpendiculaire à l'axe x et à l'axe y, une épaisseur de couche ; et
au moins une couche métallique (136) qui est montée à plat au niveau de la couche diélectrique (114) ; **caractérisé en ce que**
le composite stratifié est, le long de l'axe z, exempt d'un plan de symétrie qui est orienté parallèlement au plan xy, et
la couche diélectrique (114) présente un matériau diélectrique qui a
- un module d'élasticité E dans la plage entre 1 et 20 GPa et
- le long de l'axe x et le long de l'axe y, un coefficient d'extension thermique dans la plage entre 0 et 17 ppm/K,
le matériau diélectrique présentant un comportement au fluage qui est déterminé par au moins une des propriétés suivantes :
(a) une déformabilité plastique dans la plage entre 0,01 % et 10 %, en particulier dans la plage entre 0,1 % et 5 % et plus particulièrement dans la plage entre 0,2 % et 2 %,
(b) une déformabilité viscoélastique dans la plage entre 0 % et 10 %, en particulier dans la plage entre 0 % et 5 % et plus particulièrement dans la plage entre 0 % et 3 %.

7. Procédé selon la revendication précédente, présentant en outre
la réalisation d'un évidement dans la couche diélectrique (114) et/ou dans une couche centrale diélectrique ; et
l'introduction d'un composant électronique (120) dans l'évidement.

8. Procédé selon la revendication précédente, **caractérisé en ce que**
l'évidement est plus grand que le composant électronique (120) de sorte que, après une introduction du composant électronique (120) dans l'évidement, il reste un espace creux (221).

9. Procédé selon l'une quelconque des deux revendications précédentes, présentant en outre
si le composant électronique (120) est introduit dans la couche diélectrique (214b),
l'application d'une autre couche diélectrique (214a) sur la couche diélectrique (214b) et les composants électroniques (120), **caractérisé en ce que** l'autre couche diélectrique (214a) a les mêmes propriétés que la couche diélectrique (214b) ; et
si le composant électronique est intégré dans la couche centrale diélectrique,
l'application de la couche diélectrique sur la couche centrale diélectrique et le composant électronique.

10. Procédé selon l'une quelconque des revendications précédentes 6 à 9, présentant en outre
la réalisation d'une couche métallique (134) sur la couche diélectrique.

11. Procédé selon l'une quelconque des revendications précédentes 6 à 10, présentant en outre
le pressage de toutes les couches de la carte de circuits imprimés (200).

12. Procédé de fabrication d'une structure de cartes de circuits imprimés, le procédé présentant
la fabrication d'une première carte de circuits imprimés (200) avec un procédé selon l'une quelconque des revendications précédentes 6 à 11 ;
la fabrication d'une seconde carte de circuits imprimés (200) avec un procédé selon l'une quelconque des revendications précédentes 6 à 11 ; et
l'assemblage de la première carte de circuits imprimés (200) et la seconde carte de circuits imprimés (200) de sorte que la structure de cartes de circuits imprimés résultante présente au moins une épaisseur qui résulte de la somme d'une première épaisseur de la première carte de circuits imprimés et d'une seconde épaisseur de la seconde carte de circuits imprimés.

13. Procédé selon la revendication précédente, **caractérisé en ce que**
la structure de cartes de circuits imprimés résultante présente une suite de couche totale symétrique.

14. Procédé de fabrication de deux cartes de circuits imprimés traitées, le procédé présentant
l'établissement d'un composite stratifié (505) présentant
une première carte de circuits imprimés (500a) selon l'une quelconque des revendications 1 à 5,
une seconde carte de circuits imprimés (500b) selon l'une quelconque des revendications 1 à 5 et
une couche de détachement (590) qui est agencée entre la première carte de circuits imprimés et la seconde carte de circuits imprimés ;
le traitement du composite stratifié (505) entier ; et
la séparation du composite stratifié (505) sur la couche de détachement (590) de sorte qu'une première carte de circuits imprimés (500a) traitée et une seconde carte de circuits imprimés (500b) traitée apparaissent avec respectivement une structure de couche asymétrique.

15. Procédé selon la revendication précédente, présentant au moins une des caractéristiques suivantes :
**caractérisé en ce que** le composite stratifié (505) structuré présente, le long de l'axe z, un plan de symétrie qui est orienté parallèlement au plan xy ;
la couche de détachement (590) présentant un matériau de réduction d'adhérence imprimable et le procédé présentant en outre
l'impression du matériau de réduction d'adhérence sur au moins une zone partielle de la première carte de circuits imprimés (500a) ou sur au moins une zone partielle de la seconde carte de circuits imprimés (500a).
